(19) Europäisches Patentamt
European Patent Office
Office européen des brevets

(11) EP 4 455 789 A1

(12) **EUROPEAN PATENT APPLICATION**
published in accordance with Art. 153(4) EPC

(43) Date of publication:
**30.10.2024 Bulletin 2024/44**

(21) Application number: **22910982.2**

(22) Date of filing: **12.12.2022**

(51) International Patent Classification (IPC):
***G03F 7/004*** (2006.01) ***G03F 7/033*** (2006.01)
***G03F 7/038*** (2006.01) ***G03F 7/20*** (2006.01)

(52) Cooperative Patent Classification (CPC):
**G03F 7/004; G03F 7/033; G03F 7/038; G03F 7/20**

(86) International application number:
**PCT/JP2022/045665**

(87) International publication number:
**WO 2023/120274 (29.06.2023 Gazette 2023/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **20.12.2021 JP 2021206080**

(71) Applicant: **TOKYO OHKA KOGYO CO., LTD.**
**Kawasaki-shi, Kanagawa 211 0012 (JP)**

(72) Inventor: **MIZUSAWA, Ryuma**
**Kawasaki-shi, Kanagawa 211-0012 (JP)**

(74) Representative: **Plasseraud IP**
**104 Rue de Richelieu**
**CS92104**
**75080 Paris Cedex 02 (FR)**

# (54) PHOTOCURABLE COMPOSITION AND METHOD FOR FORMING PATTERN

(57) The present invention employs a photocurable composition including an acrylic resin (AC), an epoxy group-containing compound (A) (excluding a component corresponding to the acrylic resin (AC)), and a cationic polymerization initiator (I). The acrylic resin (AC) has a glass transition point of 0°C or lower and has a constitutional unit (ac1) derived from an epoxy group-containing acrylic monomer. A content proportion of the constitutional unit (ac1) in a total amount (100% by mass) of all constitutional units constituting the acrylic resin (AC) is greater than 0% by mass and less than 50% by mass.

EP 4 455 789 A1

## Description

[Technical Field]

The present invention relates to a photocurable composition and a method for forming a pattern.
Priority is claimed on Japanese Patent Application No. 2021-206080, filed on December 20, 2021, the content of which is incorporated herein by reference.

[Background Art]

With improvement of the performance of electronic components, miniaturization of semiconductor devices, an increase in operation speed, and high-density wiring are promoted, and various package forms corresponding thereto have been suggested. For example, a package (a hollow package) having a hollow structure in which a wiring board on which an electrode is formed is kept hollow has been used.
The hollow package can be produced as follows.
A wiring board is coated with a photosensitive composition such that an electrode is surrounded, and exposure through a photomask, post exposure bake (PEB), and development are performed in this order to form a sidewall serving as a spacer. Next, a hollow structure is prepared by bonding a top plate part onto the side wall. Subsequently, a hollow package is produced by performing molding with a mold.
For example, a photocurable adhesive material containing a photocationic polymerizable compound and a polymerization initiator which generates a cation species by irradiation with light or heating has been suggested as the photosensitive composition (for example, Patent Document 1).

[Citation List]

[Patent Document]

[Patent Document 1] Japanese Unexamined Patent Application, First Publication No. 2002-97443

[Summary of Invention]

[Technical Problem]

In the production of electronic components, a photosensitive composition is required to have various characteristics.
In a case of producing the above-described hollow package, the photosensitive composition is used as a material for a side wall serving as a spacer. The side wall is required to have adhesiveness to the top plate part. Further, since a chemical liquid treatment step is performed in the production of the electronic components in many cases, the side wall is also required to have chemical resistance to such chemical liquids.
However, in terms of achieving both adhesiveness and chemical resistance, photocurable adhesive materials of the related art are required to have further improved characteristics.
The present invention has been made in consideration of the above-described circumstances, and an object thereof is to provide a photocurable composition capable of increasing adhesiveness to an object in a case of being formed into a cured film and having excellent chemical resistance, and a method for forming a pattern using the photocurable composition.

[Solution to Problem]

In order to achieve the above-described object, the present invention employs the following configurations.
That is, according to a first aspect of the present invention, there is provided a photocurable composition including: an acrylic resin (AC); an epoxy group-containing compound (A) (excluding a component corresponding to the acrylic resin (AC)); and a cationic polymerization initiator (I), in which the acrylic resin (AC) has a glass transition point of 0°C or lower and has a constitutional unit (ac1) derived from an epoxy group-containing acrylic monomer, and a content proportion of the constitutional unit (ac1) in a total amount (100% by mass) of all constitutional units constituting the acrylic resin (AC) is greater than 0% by mass and less than 50% by mass.
According to a second aspect of the present invention, there is provided a method for forming a pattern, including: a step of forming a photocurable film on a support using the photocurable composition according to the first aspect; a step of exposing the photocurable film to light; and a step of developing the photocurable film exposed to light with a

developing solution containing an organic solvent, to form a negative tone pattern.

[Advantageous Effects of Invention]

According to the present invention, it is possible to provide a photocurable composition capable of increasing adhesiveness to an object in a case of being formed into a cured film and having excellent chemical resistance, and a method for forming a pattern using the photocurable composition.

[Description of Embodiments]

In the present specification and the scope of the present patent claims, the term "aliphatic" is a relative concept used in relation to the term "aromatic", and denotes a group, a compound, or the like that has no aromaticity.

The term "alkyl group" includes a linear, branched chain-like, or cyclic monovalent saturated hydrocarbon group unless otherwise specified. The same applies to the alkyl group in an alkoxy group.

The term "alkylene group" includes a linear, branched chain-like, or cyclic divalent saturated hydrocarbon group unless otherwise specified.

The term "halogenated alkyl group" denotes a group in which some or all hydrogen atoms of an alkyl group have been substituted with halogen atoms. Examples of the halogen atom include a fluorine atom, a chlorine atom, a bromine atom, and an iodine atom.

The term "fluorinated alkyl group" denotes a group in which some or all hydrogen atoms of an alkyl group have been substituted with fluorine atoms.

The term "constitutional unit" indicates a monomer unit constituting a high molecular weight compound (a resin, a polymer, or a copolymer).

The expression "may have a substituent" includes a case where a hydrogen atom (-H) is substituted with a monovalent group and a case where a methylene group ($-CH_2-$) is substituted with a divalent group.

The term "light exposure" is a general concept for irradiation with radiation.

(Photocurable composition)

A photocurable composition according to the present embodiment contains an acrylic resin (AC), an epoxy group-containing compound (A) (here, a component corresponding to the acrylic resin (AC) is excluded), and a cationic polymerization initiator (I).

Hereinafter, each of the acrylic resin (AC), the epoxy group-containing compound (A), and the cationic polymerization initiator (I) will also be referred to as a component (AC), a component (A), and a component (I).

In a case where a photocurable film is formed of such a photocurable composition and the photocurable film is selectively exposed, since a cation moiety of the component (I) is decomposed to generate an acid in an exposed portion of the photocurable film, and an epoxy group in the component (A) and the component (AC) is subjected to ring-opening polymerization due to an action of the acid, the solubility of the component (A) and the component (AC) in a developing solution containing an organic solvent is decreased while the solubility of the component (A) and the component (AC) in the developing solution containing an organic solvent is not changed in an unexposed portion of the photocurable film. Therefore, a difference in solubility in the developing solution containing an organic solvent occurs between the exposed portion of the photocurable film and the unexposed portion of the photocurable film. Accordingly, in a case where the photocurable film is developed with the developing solution containing an organic solvent, the unexposed portion is dissolved and removed so that a negative tone pattern is formed.

<Acrylic resin (AC)>

The acrylic resin (AC) contained in the photocurable composition according to the present embodiment has a glass transition point of 0°C or lower and has a constitutional unit (ac1) derived from an epoxy group-containing acrylic monomer.

The content proportion of the constitutional unit (ac1) in the total amount (100% by mass) of all constitutional units constituting the component (AC) is greater than 0% by mass and less than 50% by mass. That is, the component (AC) has the constitutional unit (ac1) and other constitutional units (ac2).

The term "acrylic resin (AC)" denotes a polymer generated by polymerizing at least acrylic acid ester as a monomer.

The expression "epoxy group-containing acrylic monomer" denotes acrylic acid ester containing an epoxy group in a side chain.

In "acrylic acid ester", the hydrogen atom bonded to the carbon atom at the $\alpha$-position may be substituted with a substituent. The substituent ($R^{\alpha x}$) that substitutes the hydrogen atom bonded to the carbon atom at the $\alpha$-position is an atom other than the hydrogen atom or a group. Further, the carbon atom at the $\alpha$-position of acrylic acid ester indicates

the carbon atom to which the carbonyl group of acrylic acid is bonded, unless otherwise specified.

Examples of the substituent ($R^{\alpha x}$) include an alkyl group having 1 to 5 carbon atoms, a halogen atom, and a halogenated alkyl group having 1 to 5 carbon atoms.

A glass transition point Tg of the acrylic resin is calculated by the following formula (Fox formula).

$$1/(Tg + 273) = \{W1/(Tg1 + 273) + W2/(Tg2 + 273) + ...\}/100$$

Tg: glass transition point (°C) of copolymer which is acrylic resin

Tg1: glass transition point (°C) of homopolymer having repeating structure of constitutional unit (1) derived from monomer (1)

Tg2: glass transition point (°C) of homopolymer having repeating structure of constitutional unit (2) derived from monomer (2)

W1: proportion (% by mass) of constitutional unit (1) constituting acrylic resin

W2: proportion (% by mass) of constitutional unit (2) constituting acrylic resin

$$W1 + W2 + ... = 100$$

The values disclosed in the (Kaji Test Research) homepage (www.kaji-tr.com) (KTR Corporation), Polymer Material Handbook (edited by The Society of Polymer Science, CRONA PUBLISHING CO., LTD., first edition, published on February 20, 1973), the acrylic product catalog (KYOEISHA CHEMICAL Co., Ltd.), and Polymer Data Handbook Basic Edition (edited by The Society of Polymer Science, BAIFUKAN CO., LTD., published on January 30, 1986) are employed as the glass transition point of the homopolymer.

For example, the glass transition point Tg (°C) of the acrylic resin, which is a copolymer of a constitutional unit derived from 2-methoxyethyl acrylate and a constitutional unit derived from n-butyl acrylate, can be calculated in the following manner.

As the monomer (1), 2-methoxyethyl acrylate is used. The glass transition point of the homopolymer having a repeating structure of the constitutional unit (1) derived from the monomer (1) is -50°C, and the proportion of the constitutional unit (1) is set to 73% by mass.

As the monomer (2), n-butyl acrylate is used. The glass transition point of the homopolymer having a repeating structure of the constitutional unit (2) derived from the monomer (2) is -56°C, and the proportion of the constitutional unit (2) is set to 27% by mass.

The glass transition point Tg (°C) of the acrylic resin, which is a copolymer of the constitutional unit (1) and the constitutional unit (2), is calculated by the following equation.

$$1/(Tg + 273) = \{73/(-50 + 273) + 27/(-56 + 273)\}/100$$

$Tg \approx -52°C$

The glass transition point Tg of the component (AC) is 0°C or lower, preferably -100°C or higher and 0°C or lower, more preferably -75°C or higher and -5°C or lower, and still more preferably -65°C or higher and -10°C or lower.

In a case where the glass transition point Tg of the component (AC) is lower than or equal to the upper limits of the above-described ranges, the adhesiveness to an object in a case of forming the composition into a cured film is increased, and the reliability is improved. Meanwhile, in a case where the glass transition point thereof is higher than or equal to the lower limits of the above-described ranges, the chemical resistance of the resin pattern can be further enhanced, and the lithography characteristics during pattern formation are improved.

The glass transition point Tg of the component (AC) can be controlled by selecting the kind of the constitutional unit constituting the component (AC) or adjusting the content proportion of the constitutional unit.

<<Constitutional unit (ac1)>>

The component (AC) has a constitutional unit (ac1) derived from an epoxy group-containing acrylic monomer.

The expression "constitutional unit derived from an epoxy group-containing acrylic monomer" denotes a constitutional unit that is formed by cleavage of an ethylenic double bond of an epoxy group-containing acrylic monomer.

Examples of the constitutional unit (ac1) include a constitutional unit containing an epoxy group-containing group in a side chain. Here, "epoxy group-containing group" is not particularly limited, and examples thereof include a group consisting only of an epoxy group, a group consisting only of an alicyclic epoxy group, and a group containing an epoxy group or an alicyclic epoxy group and a divalent linking group.

The alicyclic epoxy group is an alicyclic group having an oxacyclopropane structure which is 3-membered ring

ether, and specifically, the alicyclic epoxy group is a group having an alicyclic group and an oxacyclopropane structure.

An alicyclic group which is a basic skeleton of the alicyclic epoxy group may be monocyclic or polycyclic. As the monocyclic alicyclic group, a cyclopropyl group, a cyclobutyl group, a cyclopentyl group, a cyclohexyl group, a cycloheptyl group, and a cyclooctyl group are exemplary examples. In addition, as the polycyclic alicyclic group, a norbornyl group, an isobornyl group, a tricyclononyl group, a tricyclodecyl group, and a tetracyclododecyl group are exemplary examples. In addition, hydrogen atoms in these alicyclic groups may be substituted with an alkyl group, an alkoxy group, a hydroxyl group, or the like.

In a case of the group containing an epoxy group or an alicyclic epoxy group and a divalent linking group, it is preferable that the epoxy group or the alicyclic epoxy group is bonded via the divalent linking group bonded to an oxygen atom (-O-) in the formula.

Here, the divalent linking group is not particularly limited, and a divalent hydrocarbon group which may have a substituent and a divalent linking group including a heteroatom are suitable exemplary examples.

In regard to divalent hydrocarbon group which may have substituent:

Such a divalent hydrocarbon group may be an aliphatic hydrocarbon group or an aromatic hydrocarbon group; and the aliphatic hydrocarbon group in the divalent hydrocarbon group may be saturated or unsaturated, and in general, it is preferable that the aliphatic hydrocarbon group is saturated.

More specific examples of the aliphatic hydrocarbon group include a linear or branched chain-like aliphatic hydrocarbon group and an aliphatic hydrocarbon group having a ring in the structure thereof.

The number of carbon atoms in the above-described linear aliphatic hydrocarbon group is preferably 1 to 10, more preferably 1 to 6, still more preferably 1 to 4, and most preferably 1 to 3. As the linear aliphatic hydrocarbon group, a linear alkylene group is preferable, and specific examples thereof include a methylene group [$-CH_2-$], an ethylene group [$-(CH_2)_2-$], a trimethylene group [$-(CH_2)_3-$], a tetramethylene group [$-(CH_2)_4-$], and a pentamethylene group [$-(CH_2)_5-$]. The number of carbon atoms in the above-described branched aliphatic hydrocarbon group is preferably 2 to 10, more preferably 2 to 6, still more preferably 2 to 4, and most preferably 2 to 3. As the branched aliphatic hydrocarbon group, a branched alkylene group is preferable, and specific examples thereof include alkylalkylene groups, for example, alkylmethylene groups such as $-CH(CH_3)-$, $-CH(CH_2CH_3)-$, $-C(CH_3)_2-$, $-C(CH_3)(CH_2CH_3)-$, $-C(CH_3)(CH_2CH_2CH_3)-$, and $-C(CH_2CH_3)_2-$; alkylethylene groups such as $-CH(CH_3)CH_2-$, $-CH(CH_3)CH(CH_3)-$, $-C(CH_3)_2CH_2-$, $-CH(CH_2CH_3)CH_2-$, and $-C(CH_2CH_3)_2-CH_2-$; alkyltrimethylene groups such as $-CH(CH_3)CH_2CH_2-$ and $-CH_2CH(CH_3)CH_2-$; and alkyltetramethylene groups such as $-CH(CH_3)CH_2CH_2CH_2-$ and $-CH_2CH(CH_3)CH_2CH_2-$. As the alkyl group in the alkylalkylene group, a linear alkyl group having 1 to 5 carbon atoms is preferable.

Examples of the aliphatic hydrocarbon group having a ring in the structure thereof include an alicyclic hydrocarbon group (a group in which two hydrogen atoms have been removed from an aliphatic hydrocarbon ring), a group in which the alicyclic hydrocarbon group is bonded to the terminal of the linear or branched aliphatic hydrocarbon group, and a group in which the alicyclic hydrocarbon group is interposed in the middle of the linear or branched aliphatic hydrocarbon group. As the linear or branched aliphatic hydrocarbon group, the same as those described above is an exemplary example.

The number of carbon atoms in the alicyclic hydrocarbon group is preferably 3 to 20 and more preferably 3 to 12.

The alicyclic hydrocarbon group may be a polycyclic group or a monocyclic group. As the monocyclic alicyclic hydrocarbon group, a group formed by removing two hydrogen atoms from a monocycloalkane is preferable. The monocycloalkane has preferably 3 to 6 carbon atoms, and specific examples thereof include cyclopentane and cyclohexane.

As the polycyclic alicyclic hydrocarbon group, a group in which two hydrogen atoms have been removed from a polycycloalkane is preferable. As the polycycloalkane, a group having 7 to 12 carbon atoms is preferable. Specific examples of the polycycloalkane include adamantane, norbornane, isobornane, tricyclodecane, and tetracyclododecane.

The aromatic hydrocarbon group in the divalent hydrocarbon group is a hydrocarbon group having at least one aromatic ring. The aromatic ring is not particularly limited as long as the aromatic ring has a cyclic conjugated system having $(4n + 2)$ pieces of $\pi$ electrons, and may be monocyclic or polycyclic. The number of carbon atoms in the aromatic ring is preferably 5 to 30, more preferably 5 to 20, still more preferably 6 to 15, and particularly preferably 6 to 12. Specifically, as the aromatic ring, an aromatic hydrocarbon ring such as benzene, naphthalene, anthracene, and phenanthrene; and an aromatic heterocyclic ring in which some carbon atoms constituting the aromatic hydrocarbon ring have been substituted with heteroatoms are exemplary examples. Examples of the heteroatom in the aromatic heterocyclic rings include an oxygen atom, a sulfur atom, and a nitrogen atom. Specific examples of the aromatic heterocyclic ring include a pyridine ring and a thiophene ring.

Specifically, as the aromatic hydrocarbon group, a group (an arylene group or a heteroarylene group) formed by removing two hydrogen atoms from the aromatic hydrocarbon ring or the aromatic heterocyclic ring; a group formed by removing two hydrogen atoms from an aromatic compound (for example, biphenyl, fluorene, or the like) having two or more aromatic rings; and a group (for example, a group in which one hydrogen atom is further removed from an aryl group in an arylalkyl group such as a benzyl group, a phenethyl group, a 1-naphthylmethyl group, a 2-naphthylmethyl group, a 1-naphthylethyl group, and a 2-naphthylethyl group) in which one hydrogen atom of a group (an aryl group or

a heteroaryl group) formed by removing one hydrogen atom from the aromatic hydrocarbon ring or the aromatic heterocyclic ring is substituted with an alkylene group are exemplary examples. The number of carbon atoms in the alkylene group which is bonded to the above-described aryl group or heteroaryl group is preferably 1 to 4, more preferably 1 or 2, and particularly preferably 1.

The divalent hydrocarbon group may have a substituent.

The linear or branched aliphatic hydrocarbon group as the divalent hydrocarbon group may or may not have a substituent. Examples of the substituent include a fluorine atom, a fluorinated alkyl group having 1 to 5 carbon atoms which has been substituted with a fluorine atom, and a carbonyl group.

The alicyclic hydrocarbon group in the aliphatic hydrocarbon group including a ring in the structure thereof, as the divalent hydrocarbon group, may or may not have a substituent. As the substituent, an alkyl group, an alkoxy group, a halogen atom, a halogenated alkyl group, a hydroxyl group, and a carbonyl group are exemplary examples.

As the alkyl group as the above-described substituent, an alkyl group having 1 to 5 carbon atoms is preferable, and a methyl group, an ethyl group, a propyl group, an n-butyl group, or a tert-butyl group is most preferable.

As the alkoxy group as the above-described substituent, an alkoxy group having 1 to 5 carbon atoms is preferable, a methoxy group, an ethoxy group, an n-propoxy group, an iso-propoxy group, an n-butoxy group, or a tert-butoxy group is preferable, and a methoxy group or an ethoxy group is most preferable.

As the halogen atom as the above-described substituent, a fluorine atom, a chlorine atom, a bromine atom, and an iodine atom are exemplary examples. Among these, a fluorine atom is preferable.

Examples of the halogenated alkyl group as the substituent include groups in which some or all hydrogen atoms in the above-described alkyl groups have been substituted with the above-described halogen atoms.

In the alicyclic hydrocarbon group, some carbon atoms constituting the ring structure thereof may be substituted with a substituent having a heteroatom. As the substituent having a heteroatom, -O-, -C(=O)-O-, -S-, $-S(=O)_2-$, or $-S(=O)_2-O-$ is preferable.

In the aromatic hydrocarbon group as the divalent hydrocarbon group, a hydrogen atom in the aromatic hydrocarbon group may be substituted with a substituent. For example, the hydrogen atom bonded to the aromatic ring in the aromatic hydrocarbon group may be substituted with a substituent. As the substituent, an alkyl group, an alkoxy group, a halogen atom, a halogenated alkyl group, and a hydroxyl group are exemplary examples.

As the alkyl group as the above-described substituent, an alkyl group having 1 to 5 carbon atoms is preferable, and a methyl group, an ethyl group, a propyl group, an n-butyl group, or a tert-butyl group is most preferable.

As the alkoxy group, the halogen atom, and the halogenated alkyl group as the above-described substituent, the same as exemplary examples of the substituent which substitutes the hydrogen atom in the alicyclic hydrocarbon group is an exemplary example.

In regard to divalent linking group having heteroatom:

The heteroatom in the divalent linking group including a heteroatom is an atom other than a carbon atom and a hydrogen atom, and an oxygen atom, a nitrogen atom, a sulfur atom, and a halogen atom are exemplary examples.

In the divalent linking group including a heteroatom, preferred examples of the linking group include -O-, -C(=O)-O-, -C(=O)-, -O-C(=O)-O-; -C(=O)-NH-, -NH-, -NH-C(=O)-O-, -NH-C(=NH)- (H may be substituted with a substituent such as an alkyl group, an acyl group, and the like); -S-, $-S(=O)_2-$, $-S(=O)_2-O-$, and a group represented by Formulae $-Y^{21}-O-Y^{22}-$, $-Y^{21}-O-$, $-Y^{21}-C(=O)-O-$, $-C(=O)-O-Y^{21}$, $-[Y^{21}-C(=O)-O]_{m''}-Y^{22}-$, or $-Y^{21}-O-C(=O)-Y^{22}-$ [in the formulae, $Y^{21}$ and $Y^{22}$ each independently represent a divalent hydrocarbon group which may have a substituent, O represents an oxygen atom, and m" represents an integer of 0 to 3].

In a case where the divalent linking group including a heteroatom is -C(=O)-NH-, -NH-, -NH-C(=O)-O-, or -NH-C(=NH)-, H may be substituted with a substituent such as an alkyl group, an acyl group, and the like. The substituent (an alkyl group, an acyl group, or the like) has preferably 1 to 10 carbon atoms, more preferably 1 to 8 carbon atoms, and particularly preferably 1 to 5 carbon atoms.

In Formulae $-Y^{21}-O-Y^{22}-$, $-Y^{21}-O-$, $-Y^{21}-C(=O)-O-$, $-C(=O)-O-Y^{21}-$, $-[Y^{21}-C(=O)-O]_{m''}-Y^{22}-$, or $-Y^{21}-O-C(=O)-Y^{22}-$, $Y^{21}$ and $Y^{22}$ each independently represent a divalent hydrocarbon group which may have a substituent. As the divalent hydrocarbon group, the same groups as those described above as the "divalent hydrocarbon group which may have a substituent" in the definition of the above-described divalent linking group are exemplary examples.

$Y^{21}$ represents preferably a linear aliphatic hydrocarbon group, more preferably a linear alkylene group, still more preferably a linear alkylene group having 1 to 5 carbon atoms, and particularly preferably a methylene group or an ethylene group.

$Y^{22}$ represents preferably a linear or branched aliphatic hydrocarbon group and more preferably a methylene group, an ethylene group, or an alkylmethylene group. The alkyl group in the alkylmethylene group is preferably a linear alkyl group having 1 to 5 carbon atoms, more preferably a linear alkyl group having 1 to 3 carbon atoms, and most preferably a methyl group.

In the group represented by Formula $-[Y^{21}-C(=O)-O]_{m''}-Y^{22}-$, m" represents an integer of 0 to 3, preferably an integer of 0 to 2, more preferably 0 or 1, and particularly preferably 1. That is, a group represented by Formula

$-Y^{21}-C(=O)-O-Y^{22}-$ is particularly preferable as the group represented by Formula $-[Y^{21}-C(=O)-O]_{m''}-Y^{22}-$. Among these, a group represented by Formula $-(CH_2)_{a'}-C(=O)-O-(CH_2)_{b'}-$ is preferable. In the formula, a' represents an integer of 1 to 10, preferably an integer of 1 to 8, more preferably an integer of 1 to 5, still more preferably 1 or 2, and most preferably 1. b' represents an integer of 1 to 10, preferably an integer of 1 to 8, more preferably an integer of 1 to 5, still more preferably 1 or 2, and most preferably 1.

Among these, a glycidyl group is preferable as the epoxy group-containing group.

Examples of the constitutional unit (ac1) include an epoxy group-containing unit represented by any of General Formulae (a1-1) and (a1-2).

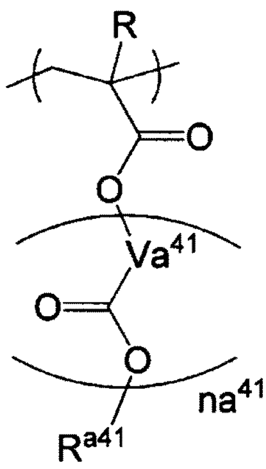
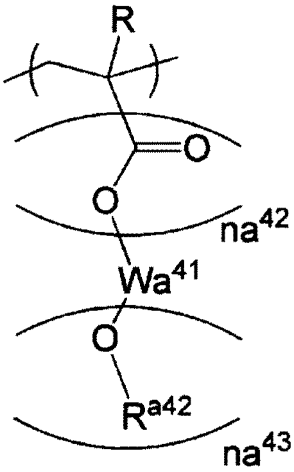

(a 1 − 1) (a 1 − 2)

[in the formulae, R is a hydrogen atom, an alkyl group having 1 to 5 carbon atoms, or a halogenated alkyl group having 1 to 5 carbon atoms, $Va^{41}$ represents a divalent hydrocarbon group which may have a substituent. $na^{41}$ represents an integer of 0 to 2. $R^{a41}$ and $R^{a42}$ each represent an epoxy group-containing group. $na^{42}$ represents 0 or 1. $Wa^{41}$ represents an ($na^{43}$ + 1)-valent aliphatic hydrocarbon group. $na^{43}$ represents an integer of 1 to 3.]

As the alkyl group having 1 to 5 carbon atoms as R in Formula (a1-1), a linear or branched alkyl group is preferable, and specifically, a methyl group, an ethyl group, a propyl group, an isopropyl group, an n-butyl group, an isobutyl group, a tert-butyl group, a pentyl group, an isopentyl group, and a neopentyl group are exemplary examples.

The halogenated alkyl group having 1 to 5 carbon atoms as R is a group in which some or all hydrogen atoms in the alkyl group having 1 to 5 carbon atoms have been substituted with halogen atoms. As the halogen atom, a fluorine atom, a chlorine atom, a bromine atom, and an iodine atom are exemplary examples. Among these, a fluorine atom is particularly preferable.

R represents preferably a hydrogen atom, an alkyl group having 1 to 5 carbon atoms, or a fluorinated alkyl group having 1 to 5 carbon atoms and more preferably a hydrogen atom or a methyl group from the viewpoint of industrial availability.

In Formula (a1-1), $Va^{41}$ represents a divalent hydrocarbon group which may have a substituent, and examples thereof include the same groups as those for the divalent hydrocarbon group which may have a substituent, described in the section of "epoxy group-containing group" above.

Among these, as the hydrocarbon group represented by $Va^{41}$, an aliphatic hydrocarbon group is preferable, a linear or branched aliphatic hydrocarbon group is more preferable, a linear aliphatic hydrocarbon group is still more preferable, and a linear alkylene group is particularly preferable.

In Formula (a1-1), $na^{41}$ represents an integer of 0 to 2 and preferably 0 or 1.

In Formulae (a1-1) and (a1-2), $R^{a41}$ and $R^{a42}$ represent an epoxy group-containing group and each have the same definition as that for "epoxy group-containing group" described above. Among these, a glycidyl group is preferable.

In Formula (a1-2), the ($na^{43}$ + 1)-valent aliphatic hydrocarbon group as $Wa^{41}$ denotes a hydrocarbon group with no aromaticity, and may be saturated or unsaturated. In general, it is preferable that the aliphatic hydrocarbon group is saturated.

Examples of the aliphatic hydrocarbon group include a linear or branched chain-like aliphatic hydrocarbon group, an aliphatic hydrocarbon group having a ring in the structure thereof, and a group obtained by combining the linear or branched chain-like aliphatic hydrocarbon group and the aliphatic hydrocarbon group having a ring in the structure thereof.

In Formula (a1-2), $na^{43}$ represents an integer of 1 to 3 and preferably 1 or 2.

Specific examples of the constitutional unit represented by Formula (a1-1) or (a1-2) are shown below.

In the following formulae, $R^{\alpha}$ represents a hydrogen atom, a methyl group, or a trifluoromethyl group.

$R^{a51}$ represents a divalent hydrocarbon group having 1 to 8 carbon atoms. $R^{a52}$ represents a divalent hydrocarbon group having 1 to 20 carbon atoms. $R^{a53}$ represents a hydrogen atom or a methyl group. $na^{51}$ represents an integer of 0 to 10.

$R^{a51}$, $R^{a52}$, and $R^{a53}$ may be the same as or different from each other.

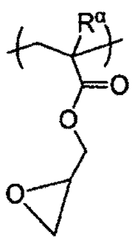
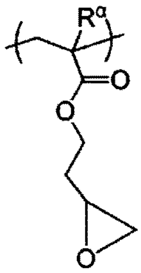
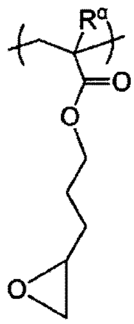

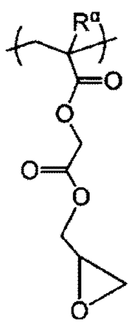
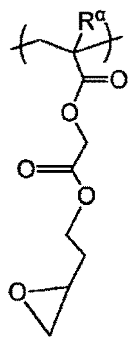
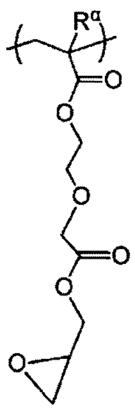
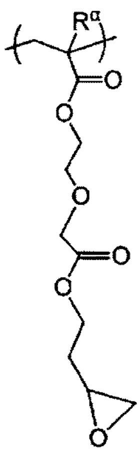
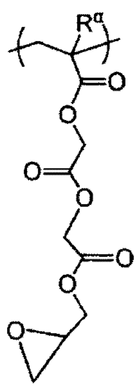
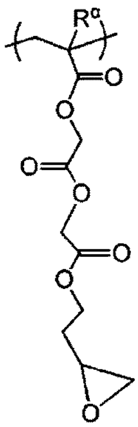

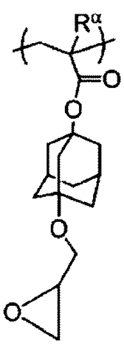
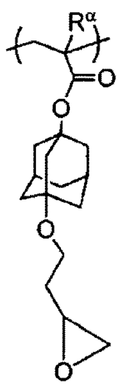
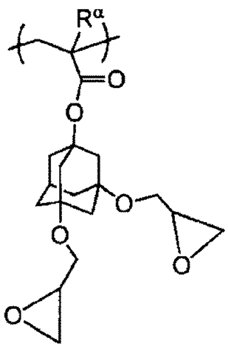
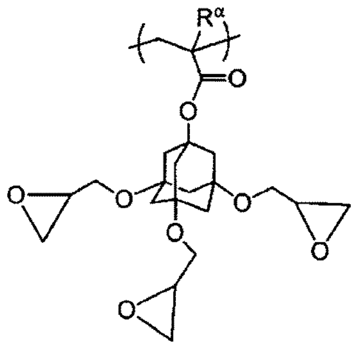

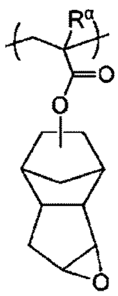 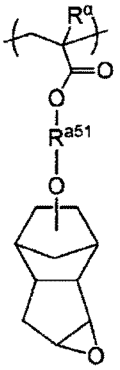 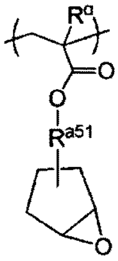 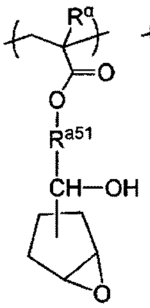 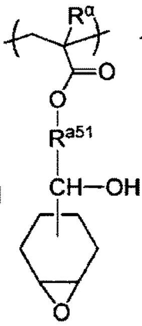 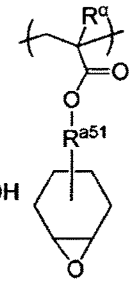

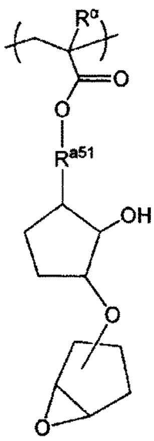 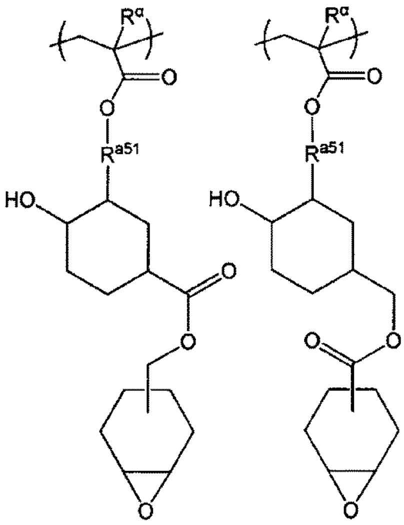 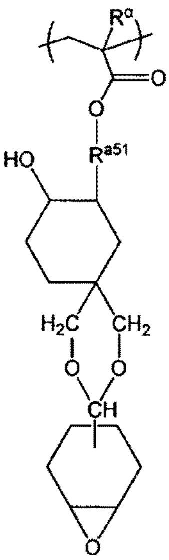 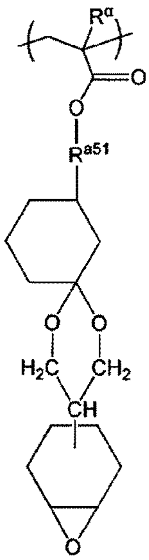

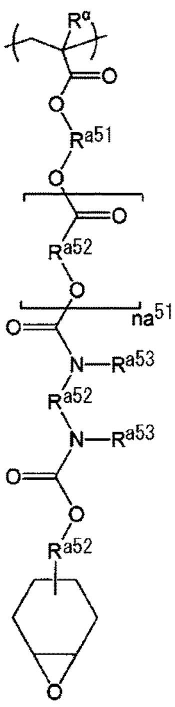 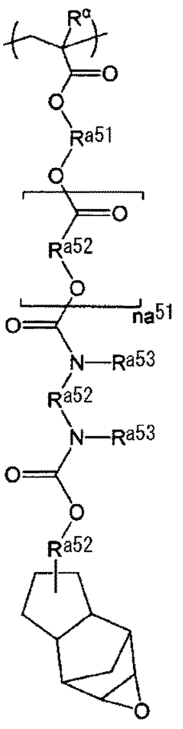 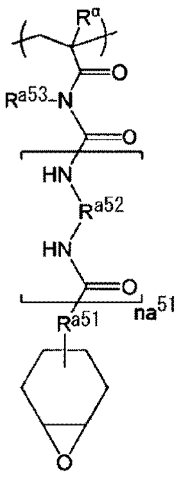 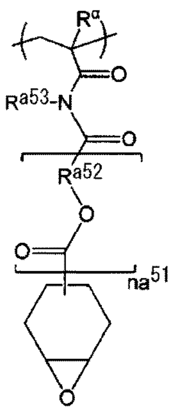

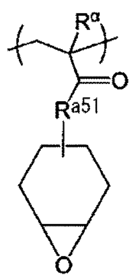 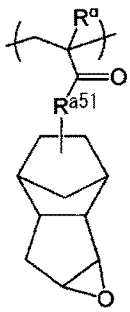 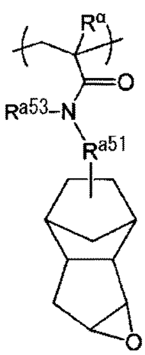 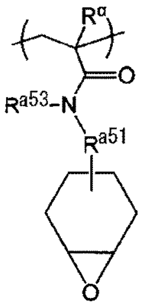 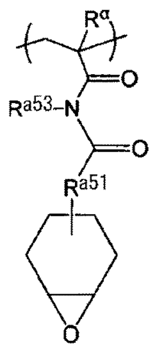 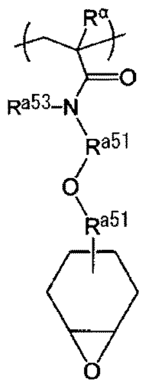

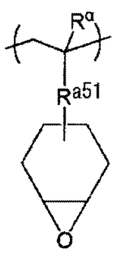 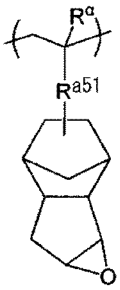 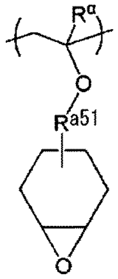 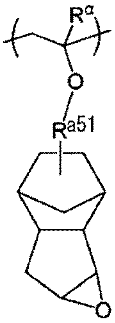 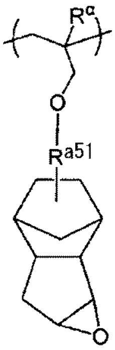 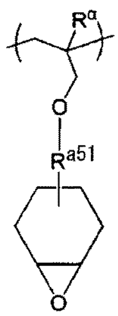 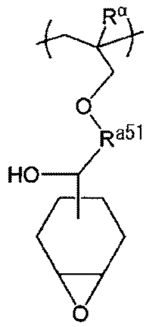

The constitutional unit (ac1) of the component (AC) may be used alone or two or more kinds thereof.

An epoxy group-containing unit represented by General Formula (a1-1) is preferable as the constitutional unit (ac1).

The content proportion of the constitutional unit (ac1) in the total amount (100% by mass) of all constitutional units constituting the component (AC) is, for example, greater than 0% by mass and less than 50% by mass, preferably 0.05% by mass or greater and 40% by mass or less, more preferably 0.05% by mass or greater and 20% by mass or less, still more preferably 0.10% by mass or greater and 10% by mass or less, and particularly preferably 0.20% by mass or greater and 5% by mass or less.

In a case where the content proportion of the constitutional unit (ac1) is greater than the lower limits of the above-described ranges, the chemical resistance of the resin pattern is further enhanced, the hardness of the cured film is increased, and the lithography characteristics during the pattern formation are improved. Meanwhile, in a case where the content proportion thereof is less than the upper limits of the above-described ranges, the chemical resistance of the resin pattern is further enhanced, the adhesiveness to an object in a case of forming the composition into a cured film is increased, and the reliability is improved.

<<Constitutional unit (ac2)>>

The component (AC) has other constitutional units (ac2) in addition to the constitutional unit (ac1) described above.

The constitutional unit (ac2) is not limited as long as the glass transition point of the component (AC), which is a copolymer with the constitutional unit (ac1), reaches 0°C or lower, and examples thereof include a constitutional unit derived from acrylic acid ester other than the epoxy group-containing acrylic monomer, a constitutional unit derived from an acrylic acid, and other constitutional units derived from polymerizable compounds.

Here, "acrylic acid ester" and "acrylic acid" may be formed such that a hydrogen atom bonded to a carbon atom at an $\alpha$-position may be substituted with a substituent. Examples of the substituent ($R^{\alpha x}$) that substitutes a hydrogen atom bonded to a carbon atom at the $\alpha$-position include an alkyl group having 1 to 5 carbon atoms, a halogen atom, and a halogenated alkyl group having 1 to 5 carbon atoms.

Examples of the monomer from which the constitutional unit (ac2) is derived include (meth)acrylic acid alkyl ester such as 2-ethylhexyl acrylate, n-butyl acrylate, isobutyl acrylate, ethyl acrylate, methyl acrylate, n-butyl methacrylate, isobutyl methacrylate, ethyl methacrylate, or methyl methacrylate; (meth)acrylic acid hydroxyalkyl ester such as 2-hydroxyethyl acrylate, 2-hydroxypropyl acrylate, 2-hydroxyethyl methacrylate, or 2-hydroxypropyl methacrylate;

(meth)acrylic acid alkoxyalkyl ester such as 2-methoxyethyl acrylate or 2-methoxyethyl methacrylate; monocarboxylic acid such as acrylic acid, methacrylic acid, or crotonic acid; dicarboxylic acids such as maleic acid, fumaric acid, or itaconic acid; a methacrylic acid having a carboxy group or an ester bond, such as 2-methacryloyloxyethyl succinic acid, 2-methacryloyloxyethyl maleic acid, 2-methacryloyloxyethyl phthalic acid, or 2-methacryloxyethyl hexahydrophthalic acid; (meth)acrylic acid aryl ester such as phenyl acrylate, benzyl acrylate, phenyl methacrylate, or benzyl methacrylate; dicarboxylic acid diester such as diethyl maleate or dibutyl fumarate; a vinyl group-containing aromatic compound such as styrene, α-methylstyrene, chlorostyrene, chloromethylstyrene, vinyl toluene, hydroxystyrene, α-methylhydroxystyrene, or α-ethylhydroxystyrene; a vinyl group-containing aliphatic compound such as vinyl acetate; conjugated diolefin such as butadiene or isoprene; a nitrile group-containing polymerizable compound such as acrylonitrile or methacrylonitrile; a chlorine-containing polymerizable compound such as vinyl chloride or vinylidene chloride; and an amide bond-containing polymerizable compound such as acrylamide or methacrylamide.

Further, the term "(meth)acrylic acid" denotes one or both of acrylic acid and methacrylic acid.

The constitutional unit (ac2) of the component (AC) may be used alone or two or more kinds thereof.

Among the examples described above, as the monomer from which the constitutional unit (ac2) is derived, (meth)acrylic acid alkyl ester, (meth)acrylic acid hydroxyalkyl ester, or (meth)acrylic acid alkoxyalkyl ester is preferable.

The number of carbon atoms in the alkyl of the alkyl ester moiety in the (meth)acrylic acid alkyl ester is preferably in a range of 1 to 5.

The number of carbon atoms in the alkyl of the hydroxyalkyl ester moiety in the (meth)acrylic acid hydroxyalkyl ester is preferably in a range of 1 to 5.

The number of carbon atoms in the alkoxy of the alkoxyalkyl ester moiety in the (meth)acrylic acid alkoxyalkyl ester is preferably in a range of 1 to 3, and the number of carbon atoms in the alkyl thereof is preferably in a range of 1 to 5.

The content proportion of the constitutional unit (ac2) in the total amount (100% by mass) of all the constitutional units constituting the component (AC) is 50% by mass or greater, preferably 60% by mass or greater and 99.95% by mass or less, more preferably 80% by mass or greater and 99.95% by mass or less, still more preferably 90% by mass or greater and 99.90% by mass or less, and particularly preferably 95% by mass or greater and 99.80% by mass or less.

In a case where the content proportion of the constitutional unit (ac2) is greater than or equal to the lower limits of the above-described ranges, the chemical resistance of the resin pattern can be further enhanced. Meanwhile, in a case where the content proportion is less than or equal to the upper limits of the above-described ranges, the chemical resistance of the resin pattern can be further enhanced, and the lithography characteristics during pattern formation are improved.

The acrylic resin (AC) contained in the photocurable composition according to the present embodiment has a glass transition point of 0°C or lower and contains a copolymer in which the content proportion of the constitutional unit (ac1) described above is greater than 0% by mass and less than 50% by mass, and the copolymer may be used alone or in combination of two or more kinds thereof.

In such a component (AC), the content proportion of the constitutional unit derived from "acrylic acid ester" in the total amount (100% by mass) of all the constitutional units constituting the component (AC) is preferably 50% by mass or greater, more preferably 80% by mass or greater, still more preferably 90% by mass or greater and may be 100% by mass.

Preferred examples of the copolymer in which the content proportion of the constitutional unit (ac1) is greater than 0% by mass and less than 50% by mass include a copolymer having the constitutional unit (ac1) and a constitutional unit derived from (meth)acrylic acid alkyl ester, a copolymer having the constitutional unit (ac1) and a constitutional unit derived from (meth)acrylic acid hydroxyalkyl ester, and a copolymer having the constitutional unit (ac1) and a constitutional unit derived from (meth)acrylic acid alkoxyalkyl ester.

Alternatively, preferred examples of the copolymer in which the content proportion of the constitutional unit (ac1) is greater than 0% by mass and less than 50% by mass include a copolymer having the constitutional unit (ac1), a constitutional unit derived from (meth)acrylic acid alkoxyalkyl ester, and a constitutional unit derived from (meth)acrylic acid alkyl ester, a copolymer having the constitutional unit (ac1), a constitutional unit derived from (meth)acrylic acid alkoxyalkyl ester, and a constitutional unit derived from (meth)acrylic acid hydroxyalkyl ester, and a copolymer having the constitutional unit (ac1), a constitutional unit derived from (meth)acrylic acid hydroxyalkyl ester, and a constitutional unit derived from (meth)acrylic acid alkyl ester.

For example, in the copolymer having the constitutional unit (ac1) and other constitutional units (ac2), the content proportion of the constitutional unit (ac1) in the total amount (100% by mass) of all the constitutional units constituting the copolymer is greater than 0% by mass and 5% by mass or less, the content proportion of the constitutional unit derived from (meth)acrylic acid alkoxyalkyl ester in the total amount thereof is 30% by mass or greater and 99% by mass or less, the content proportion of the constitutional unit derived from (meth)acrylic acid hydroxyalkyl ester in the total amount thereof is 0.5% by mass or greater and 5% by mass or less, and the content proportion of the constitutional unit derived from (meth)acrylic acid alkyl ester in the total amount thereof is 20% by mass or greater and 70% by mass or less.

The component (AC) can be produced by dissolving a monomer from which the constitutional unit (ac1) is derived and a monomer from which the constitutional unit (ac2) is derived, in a polymerization solvent and adding a radical polymerization initiator such as azobisisobutyronitrile (AIBN) or dimethyl azobisisobutyrate (for example, V-601) to perform polymerization.

The weight-average molecular weight (Mw) (in terms of standard polystyrene according to the measurement by gel permeation chromatography (GPC)) of the component (AC) is not particularly limited, but is preferably in a range of 50,000 to 400,000, more preferably in a range of 60,000 to 380,000, and still more preferably in a range of 70,000 to 360,000.

The dispersity (Mw/Mn) of the component (AC) is not particularly limited, but is preferably in a range of 1.0 to 3.0, more preferably in a range of 1.0 to 2.5, and particularly preferably in a range of 1.0 to 2.0. In addition, Mn represents the number average molecular weight.

The content of the component (AC) in the photocurable composition according to the present embodiment is preferably in a range of 1 to 45 parts by mass, more preferably in a range of 1 to 40 parts by mass, still more preferably in a range of 5 to 30 parts by mass, and particularly preferably in a range of 10 to 25 parts by mass with respect to the content (100 parts by mass) of the epoxy group-containing compound (A) described below.

The content of the component (AC) in the photocurable composition according to the present embodiment is preferably in a range of 1% to 40% by mass, more preferably in a range of 3% to 30% by mass, and still more preferably in a range of 5% to 20% by mass with respect to the total amount of the solid content (100% by mass) of the photocurable composition.

<Epoxy group-containing compound (A)>

Examples of the epoxy group-containing compound (A) contained in the photocurable composition according to the present embodiment include a compound containing, in one molecule, epoxy groups sufficient for forming a negative tone pattern by exposure.

Examples of such a component (A) include a novolac type epoxy resin (hereinafter, also referred to as "component (A1)"), a bisphenol type epoxy resin (hereinafter, also referred to as "component (A2)"), and an aliphatic epoxy resin.

The component (A) may be used alone or in combination of two or more kinds thereof.

Here, the component (A) is defined as a component excluding components corresponding to the acrylic resin (AC).

<<Novolac type epoxy resin>>

Suitable examples of the novolac type epoxy resin (hereinafter, also referred to as "component (A1)") include an epoxy resin represented by General Formula (anv0).

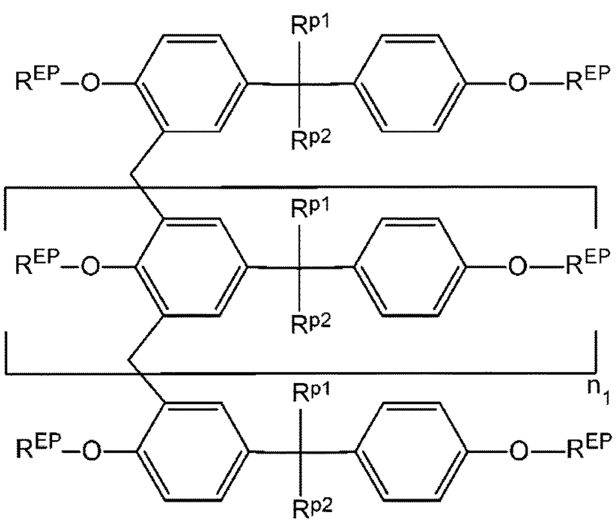

・・・(anv0)

[In the formula, $R^{p1}$ and $R^{p2}$ each independently represent a hydrogen atom or an alkyl group having 1 to 5 carbon atoms. A plurality of $R^{p1}$'s may be the same as or different from each other. A plurality of $R^{p2}$'s may be the same as or different from each other. $n_1$ represents an integer of 1 to 5. $R^{EP}$ represents an epoxy group-containing group. A plurality

of $R^{EP}$'s may be the same as or different from each other.]

In Formula (anv0), the alkyl group having 1 to 5 carbon atoms as $R^{p1}$ and $R^{p2}$ is, for example, a linear, branched, or cyclic alkyl group having 1 to 5 carbon atoms. Examples of the linear or branched alkyl group include a methyl group, an ethyl group, a propyl group, an isopropyl group, an n-butyl group, an isobutyl group, a tert-butyl group, a pentyl group, an isopentyl group, and a neopentyl group. Examples of the cyclic alkyl group, a cyclobutyl group, and a cyclopentyl group.

Among these, $R^{p1}$ and $R^{p2}$ represent preferably a hydrogen atom or a linear or branched alkyl group, more preferably a hydrogen atom or a linear alkyl group, and particularly preferably a hydrogen atom or a methyl group.

In Formula (anv0), a plurality of $R^{p1}$'s may be the same as or different from each other. A plurality of $R^{p2}$'s may be the same as or different from each other.

In Formula (anv0), $n_1$ represents an integer of 1 to 5, preferably 2 or 3, and more preferably 2.

In Formula (anv0), $R^{EP}$ represents an epoxy group-containing group.

The epoxy group-containing group as $R^{EP}$ is not particularly limited, and examples thereof include a group consisting only of an epoxy group; a group consisting only of an alicyclic epoxy group; and a group having an epoxy group or an alicyclic epoxy group and a divalent linking group.

The description for the epoxy group-containing group as $R^{EP}$ is the same as the description for "epoxy group-containing group" described above.

Among these, a glycidyl group is preferable as the epoxy group-containing group represented by $R^{EP}$.

Further, suitable examples of the component (A1) also include a resin having a constitutional unit represented by General Formula (anv1).

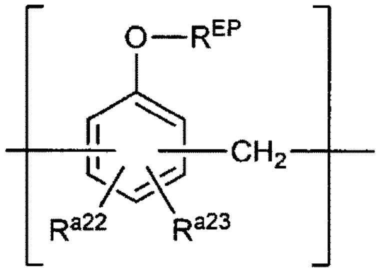

・・・(anv1)

[In the formula, $R^{EP}$ represents an epoxy group-containing group. $R^{a22}$ and $R^{a23}$ each independently represent a hydrogen atom, an alkyl group having 1 to 5 carbon atoms, or a halogen atom.]

In Formula (anv1), the alkyl group having 1 to 5 carbon atoms as $R^{a22}$ and $R^{a23}$ has the same definition as that for the alkyl group having 1 to 5 carbon atoms as $R^{p1}$ and $R^{p2}$ in Formula (anv0).

It is preferable that the halogen atom as $R^{a22}$ and $R^{a23}$ is a chlorine atom or a bromine atom.

In Formula (anv1), $R^{EP}$ has the same definition as that for $R^{EP}$ in Formula (anv0), and it is preferable that $R^{EP}$ represents a glycidyl group.

Specific examples of the constitutional unit represented by Formula (anv1) are shown below.

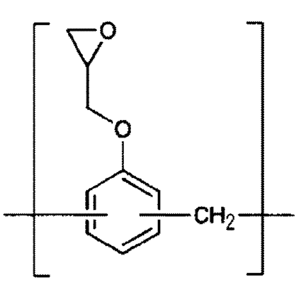

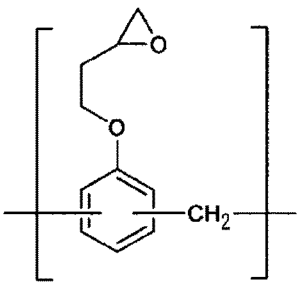

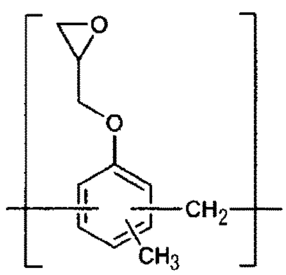

The component (A1) may be a resin consisting of only the above-described constitutional unit (anv1) or a resin having the constitutional unit (anv1) and other constitutional units.

Examples of other constitutional units include a constitutional unit represented by any of General Formulae (anv2) and (anv3).

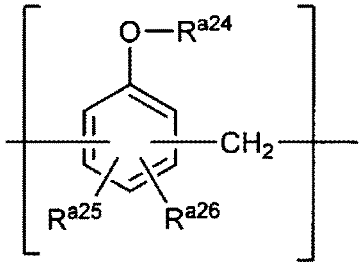

(anv2)

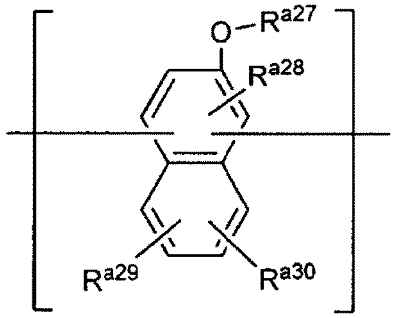

(anv3)

[In the formulae, $R^{a24}$ represents a hydrocarbon group which may have a substituent. $R^{a25}$ and $R^{a26}$, and $R^{a28}$ to $R^{a30}$ each independently represent a hydrogen atom, an alkyl group having 1 to 5 carbon atoms, or a halogen atom. $R^{a27}$ represents an epoxy group-containing group or a hydrocarbon group which may have a substituent.]

In Formula (anv2), $R^{a24}$ represents a hydrocarbon group which may have a substituent. Examples of the hydrocarbon group which may have a substituent include a linear or branched alkyl group and a cyclic hydrocarbon group.

The linear alkyl group has preferably 1 to 5 carbon atoms, more preferably 1 to 4 carbon atoms, and still more preferably 1 or 2 carbon atoms. Specific examples thereof include a methyl group, an ethyl group, an n-propyl group, an n-butyl group, and an n-pentyl group are exemplary examples. Among these, a methyl group, an ethyl group, or an n-butyl group is preferable, and a methyl group or an ethyl group is more preferable.

The branched alkyl group has preferably 3 to 10 carbon atoms and more preferably 3 to 5 carbon atoms. Specific examples thereof include an isopropyl group, an isobutyl group, a tert-butyl group, an isopentyl group, a neopentyl group a 1,1-diethylpropyl group, and a 2,2-dimethylbutyl group. Among these, an isopropyl group is preferable.

In a case where $R^{a24}$ represents a cyclic hydrocarbon group, the hydrocarbon group may be an aliphatic hydrocarbon group or an aromatic hydrocarbon group, and may be a polycyclic group or a monocyclic group.

As the aliphatic hydrocarbon group which is a monocyclic group, a group in which one hydrogen atom has been removed from a monocycloalkane is preferable. The monocycloalkane has preferably 3 to 6 carbon atoms, and specific examples thereof include cyclopentane and cyclohexane.

As the aliphatic hydrocarbon group which is a polycyclic group, a group in which one hydrogen atom has been removed from a polycycloalkane is preferable. As the polycycloalkane, a group having 7 to 12 carbon atoms is preferable, and specific examples thereof include adamantane, norbornane, isobornane, tricyclodecane, and tetracyclododecane.

In a case where the cyclic hydrocarbon group as $R^{a24}$ is an aromatic hydrocarbon group, the aromatic hydrocarbon group is a hydrocarbon group having at least one aromatic ring.

The aromatic ring is not particularly limited as long as the aromatic ring is a cyclic conjugated system having $(4n + 2)$ $\pi$ electrons and may be monocyclic or polycyclic. The number of carbon atoms in the aromatic ring is preferably in a range of 5 to 30, more preferably in a range of 5 to 20, still more preferably in a range of 6 to 15, and particularly preferably in a range of 6 to 12. Specifically, as the aromatic ring, an aromatic hydrocarbon ring such as benzene, naphthalene, anthracene, and phenanthrene; and an aromatic heterocyclic ring in which some carbon atoms constituting the aromatic hydrocarbon ring have been substituted with heteroatoms are exemplary examples. Examples of the heteroatom in the aromatic heterocyclic rings include an oxygen atom, a sulfur atom, and a nitrogen atom. Specific examples of the aromatic heterocyclic ring include a pyridine ring and a thiophene ring.

Specific examples of the aromatic hydrocarbon group as $R^{a24}$ include a group in which one hydrogen atom has been removed from the above-described aromatic hydrocarbon ring or aromatic heterocyclic ring (such as an aryl group or a heteroaryl group); a group in which one hydrogen atom has been removed from an aromatic compound having two or more aromatic rings (such as biphenyl or fluorene); and a group in which one hydrogen atom of the above-described aromatic hydrocarbon ring or aromatic heterocyclic ring has been substituted with an alkylene group (for example, an arylalkyl group such as a benzyl group, a phenethyl group, a 1-naphthylmethyl group, a 2-naphthylmethyl group, a 1-naphthylethyl group, or a 2-naphthylethyl group). The number of carbon atoms in the alkylene group which is bonded to the aromatic hydrocarbon ring or the aromatic heterocyclic ring is preferably in a range of 1 to 4, more preferably 1 or 2, and particularly preferably 1.

In Formulae (anv2) and (anv3), $R^{a25}$ and $R^{a26}$, and $R^{a28}$ to $R^{a30}$ each independently represent a hydrogen atom, an alkyl group having 1 to 5 carbon atoms, or a halogen atom.

The alkyl group having 1 to 5 carbon atoms and the halogen atom each have the same definition as that for $R^{a22}$ and $R^{a23}$ described above.

In Formula (anv3), $R^{a27}$ represents an epoxy group-containing group or a hydrocarbon group which may have a substituent. The epoxy group-containing group as $R^{a27}$ has the same definition as that for $R^{EP}$ in Formula (anv0)

described above. The hydrocarbon group as $R^{a27}$, which may have a substituent, has the same definition as that for $R^{a24}$ in Formula (anv2) described above.

Specific examples of the constitutional unit represented by any of Formulae (anv2) and (anv3) are shown below.

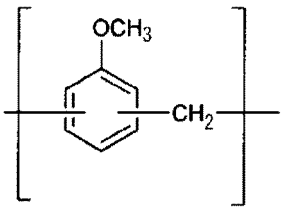
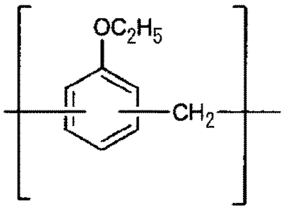
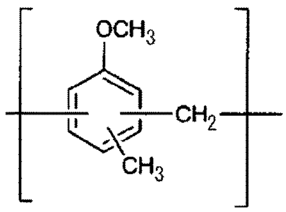

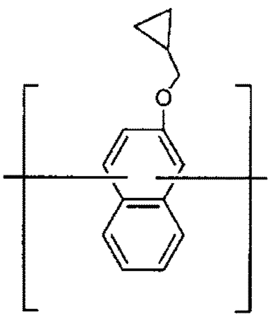
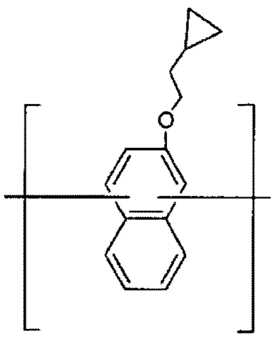
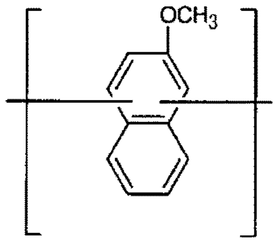

In a case where the component (A1) has other constitutional units in addition to the constitutional unit (anv1), the proportion of each constitutional unit in the component (A1) is not particularly limited, but the total amount of the constitutional units containing an epoxy group is preferably in a range of 10% to 90% by mole, more preferably in a range of 20% to 80% by mole, and still more preferably in a range of 30% to 70% by mole with respect to the total amount of all the constitutional units constituting the component (A1).

Examples of a commercially available product of the component (A1) include, as novolac type epoxy resins, jER-152, jER-154, jER-157570, and jER-157S65 (all manufactured by Mitsubishi Chemical Corporation), EPICLON N-740, EPICLON N-740, EPICLON N-770, EPICLON N-775, EPICLON N-660, EPICLON N-665, EPICLON N-670, EPICLON N-673, EPICLON N-680, EPICLON N-690, EPICLON N-695, and EPICLON HP5000 (all manufactured by DIC Corporation), and EOCN-1020 (manufactured by Nippon Kayaku Co., Ltd.).

The component (A1) may be used alone or in combination of two or more kinds thereof.

The content of the component (A1) in the photocurable composition according to the present embodiment is preferably 25% by mass or greater and more preferably 40% by mass or greater, and may be 50% by mass or greater, 75% by mass or greater, 90% by mass or greater, or 100% by mass with respect to the total amount (100% by mass) of the component (A).

<<Bisphenol type epoxy resin>>

The bisphenol type epoxy resin (hereinafter, also referred to as "component (A2)") may be a resin that has a constitutional unit having a bisphenol skeleton, and among these, a solid bisphenol type epoxy resin is preferable.

The solid bisphenol type epoxy resin denotes a resin that has a constitutional unit having a bisphenol skeleton, which is in a solid state at 25°C.

The epoxy equivalent in the component (A2) is, for example, preferably 500 g/eq. or greater, more preferably in a range of 550 to 1,200 g/eq., and still more preferably in a range of 600 to 1,000 g/eq.

Suitable examples of the component (A2) include an epoxy resin represented by General Formula (abp1).

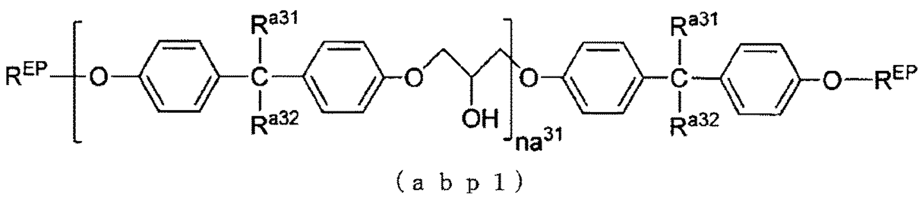

(a b p 1)

[In the formula, $R^{EP}$ represents an epoxy group-containing group. A plurality of $R^{EP}$'s may be the same as or different from each other. $R^{a31}$ and $R^{a32}$ each independently represent a hydrogen atom, an alkyl group having 1 to 5 carbon atoms, or a fluorinated alkyl group having 1 to 5 carbon atoms, $na^{31}$ represents an integer of 1 to 50.]

In Formula (abp1), $R^{EP}$ has the same definition as that for $R^{EP}$ in Formula (anv0), and it is preferable that $R^{EP}$ represents a glycidyl group.

In Formula (abp1), the alkyl group having 1 to 5 carbon atoms as $R^{a31}$ and $R^{a32}$ has the same definition as the alkyl group having 1 to 5 carbon atoms as $R^{p1}$ and $R^{p2}$ in Formula (anv0). Among these, it is preferable that $R^{a31}$ and $R^{a32}$ each represent a hydrogen atom or a methyl group.

Examples of the fluorinated alkyl group having 1 to 5 carbon atoms as $R^{a31}$ and $R^{a32}$ include a group in which some or all hydrogen atoms in the alkyl group having 1 to 5 carbon atoms as $R^{a31}$ and $R^{a32}$ described above have been substituted with fluorine atoms.

In Formula (abp1), $na^{31}$ represents an integer of 1 to 50, preferably an integer of 4 to 15, and more preferably an integer of 5 to 8.

Examples of a commercially available product which can be used as the component (A2) include JER-4005, JER-4007, and JER-4010 (all manufactured by Mitsubishi Chemical Corporation); JER-827, JER-828, JER-834, JER-1001, JER-1002, JER-1003, JER-1055, JER-1007, JER-1009, and JER-1010 (all manufactured by Mitsubishi Chemical Corporation); and EPICLON 860, EPICLON 1050, EPICLON 1051, and EPICLON 1055 (all manufactured by DIC Corporation).

The component (A2) may be used alone or in combination of two or more kinds thereof.

The content of the component (A2) in the photocurable composition according to the present embodiment is preferably 50% by mass or greater and more preferably 60% by mass or greater, and may be 70% by mass or greater, 80% by mass or greater, 90% by mass or greater, or 100% by mass with respect to the total amount (100% by mass) of the component (A).

In a case where the component (A1) and the component (A2) are used in combination, the ratio of the component (A1) to the component (A2) (component (A1)/component (A2)) in terms of the mass ratio is preferably 1/9 or greater and 7/3 or less, more preferably 2/8 or greater and 6/4 or less, and still more preferably 3/7 or greater and 5/5 or less.

In a case where the mass ratio thereof is in the above-described preferable ranges, the chemical resistance is likely to be improved, and the resolution is further enhanced.

<<Aliphatic epoxy resin>>

Suitable examples of the aliphatic epoxy resin include a compound represented by General Formula (ta1) (hereinafter, this compound will also be referred to as "component (A3)").

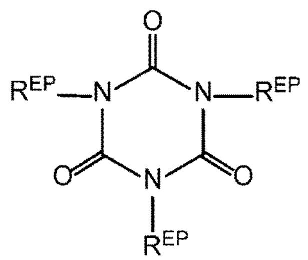

・・・(ta1)

[In the formula, $R^{EP}$ represents an epoxy group-containing group. A plurality of $R^{EP}$'s may be the same as or different from each other.]

In Formula (ta1), $R^{EP}$ represents an epoxy group-containing group, and has the same definition as that for $R^{EP}$ in Formula (anv0).

Examples of a commercially available product which can be used as the component (A3) include TEPIC series such as TEPIC, TEPIC-VL, TEPIC-PAS, TEPIC-G, TEPIC-S, TEPIC-SP, TEPIC-SS, TEPIC-HP, TEPIC-L, TEPIC-FL, and TEPIC-UC (manufactured by Nissan Chemical Industries, Ltd.); and MA-DGIC, DA-MGIC, and TOIC (manufactured by SHIKOKU KASEI HOLDINGS CORPORATION).

The component (A3) may be used alone or in combination of two or more kinds thereof.

In addition, examples of the aliphatic epoxy resin include a compound (hereinafter, also referred to as "component (m1)") having a partial structure represented by General Formula (m1).

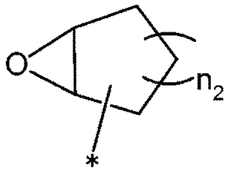

· · · (m1)

[In the formula, $n_2$ represents an integer of 1 to 4. * represents a bonding site.]

In Formula (m1), $n_2$ represents an integer of 1 to 4, preferably an integer of 1 to 3, and more preferably 2.

Examples of the component (m1) include a compound in which a plurality of partial structures represented by General Formula (m1) are bonded via a divalent linking group or a single bond. Among these, a compound in which a plurality of the partial structures represented by General Formula (m1) described above are bonded via a divalent linking group is preferable.

Here, the divalent linking group is not particularly limited, and suitable examples thereof include a divalent hydrocarbon group which may have a substituent and a divalent linking group having a heteroatom.

Here, the divalent hydrocarbon group which may have a substituent and the divalent linking group having a heteroatom each have the same definition as that for the divalent hydrocarbon group which may have a substituent and the divalent linking group having a heteroatom, described in the section of "epoxy group-containing group" above. Among these, a divalent linking group having a heteroatom is preferable, and a group represented by $-Y^{21}-C(=O)-O-$ or a group represented by $-C(=O)-O-Y^{21}-$ is more preferable. $Y^{21}$ represents preferably a linear aliphatic hydrocarbon group, more preferably a linear alkylene group, still more preferably a linear alkylene group having 1 to 5 carbon atoms, and particularly preferably a methylene group or an ethylene group.

Examples of a commercially available product which can be used as the aliphatic epoxy resin include ADEKA RESIN EP-4080S, ADEKA RESIN EP-4085S, and ADEKA RESIN EP-4088S (all manufactured by ADEKA CORPORATION); CELLOXIDE 2021P, CELLOXIDE 2081, CELLOXIDE 2083, CELLOXIDE 2085, CELLOXIDE 8000, CELLOXIDE 8010, EHPE-3150, EPOLEAD PB 3600, and EPOLEAD PB4700 (all manufactured by Daicel Corporation); and DENACOL EX-211L, EX-212L, EX-214L, EX-216L, EX-321L, and EX-850L (all manufactured by Nagase ChemteX Corporation).

Further, as the epoxy group-containing compound (A), each of a compound represented by Chemical Formula (A4-1) and a compound represented by Chemical Formula (A4-2) may be used in addition to the above-described resins.

Examples of a commercially available product that can be used as the compound represented by Chemical Formula (A4-1) include TECHMORE VG-3101L (manufactured by Printec, Inc.).

Examples of a commercially available product that can be used as the compound represented by Chemical Formula (A4-2) include SHOFREE (registered trademark) BATG (manufactured by Showa Denko K.K.).

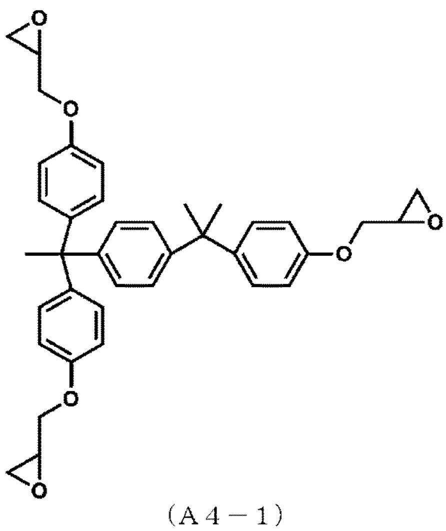

(A4-1)

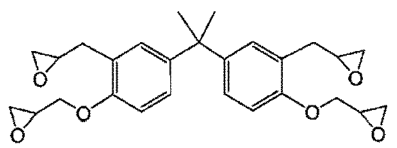

(A4-2)

Further, examples of the epoxy group-containing compound (A) include trimethylolpropane triglycidyl ether and glycerin triglycidyl ether; pentaerythritol tetraglycidyl ether, ditrimethylolpropane tetraglycidyl ether, diglycerin tetraglycidyl ether, and erythritol tetraglycidyl ether; xylitol pentaglycidyl ether, dipentaerythritol pentaglycidyl ether, and inositol pentaglycidyl ether; and dipentaerythritol hexaglycidyl ether, sorbitol hexaglycidyl ether, and inositol hexaglycidyl ether.

In the photocurable composition according to the present embodiment, a component containing at least one

epoxy resin selected from the group consisting of a bisphenol type epoxy resin (A2) and a novolac type epoxy resin (A1) is preferable as the component (A).

Among these, a component containing a solid bisphenol type epoxy resin and the component (A1) is more preferable, and a component containing an epoxy resin represented by General Formula (abp1) and an epoxy resin represented by General Formula (anv0) is still more preferable as the component (A).

The weight-average molecular weight of the component (A) in terms of polystyrene is preferably in a range of 100 to 300,000, more preferably in a range of 200 to 200,000, and still more preferably in a range of 300 to 200,000. In a case where the weight-average molecular weight thereof is in the above-described ranges, the chemical resistance of the resin pattern is likely to be enhanced, and the hardness of a cured film to be formed is sufficiently increased.

The content of the component (A) in the photocurable composition according to the present embodiment may be adjusted according to the film thickness and the like of the photocurable film intended to be formed.

The content of the component (A) in the photocurable composition according to the present embodiment is preferably in a range of 40% to 99% by mass, more preferably in a range of 50% to 95% by mass, and still more preferably in a range of 60% to 90% by mass with respect to the total amount (100% by mass) of the solid content in the photocurable composition.

The mixing ratio between the acrylic resin (AC) and the epoxy group-containing compound (A) (component (A)/component (AC)) in the photocurable composition according to the present embodiment in terms of the mass ratio is preferably in a range of 60/40 to 95/5, more preferably in a range of 65/35 to 90/10, and still more preferably in a range of 70/30 to 90/10.

In a case where the mass ratio thereof is greater than or equal to the lower limits of the above-described preferable ranges, the chemical resistance of the resin pattern is likely to be enhanced, and the hardness of a cured film to be formed is sufficiently increased. Meanwhile, in a case of the mass ratio thereof is less than or equal to the upper limits of the above-described preferable ranges, the adhesiveness to an object in a case of forming the composition into the cured film is likely to be further enhanced.

<Cationic polymerization initiator (I)>

The cationic polymerization initiator (I) contained in the photocurable composition according to the present embodiment is a compound which generates a cation by irradiation with active energy rays, for example, excimer laser light such as ultraviolet rays, far ultraviolet rays, KrF, or ArF, X-rays, and electron beams and in which the cation can serve as a polymerization initiator.

Examples of the component (I) include an onium borate salt (hereinafter, also referred to as "component (I1)") and a compound represented by General Formula (12-1) or (I2-2) (hereinafter, also referred to as "component (I2)"), and a compound represented by General Formula (13-1) or (I3-2) (hereinafter, also referred to as "component (I3)").

<<Onium borate salt>>

The onium borate salt (component (I1)) generates a relatively strong acid upon light exposure. Therefore, in a case where a pattern is formed of the photocurable composition containing the component (I1), sufficient sensitivity can be obtained so that a satisfactory pattern is formed. In addition, the risk of toxicity and metal corrosion is decreased by using the component (I1).

Suitable examples of the component (I1) include a compound represented by General Formula (I1).

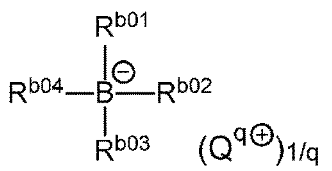 · · · (I1)

[In the formula, $R^{b01}$ to $R^{b04}$ each independently represent an aryl group which may have a substituent or a fluorine atom. q represents an integer of 1 or greater, and $Q^{q+}$ represents a q-valent organic cation.]

· Anionic moiety

In Formula (I1), the aryl group as $R^{b01}$ to $R^{b04}$ has preferably 5 to 30 carbon atoms, more preferably 5 to 20 carbon atoms, still more preferably 6 to 15 carbon atoms, and particularly preferably 6 to 12 carbon atoms. Specific examples thereof include a naphthyl group, a phenyl group, and an anthracenyl group, and a phenyl group is preferable

from the viewpoint of availability.

The aryl group as $R^{b01}$ to $R^{b04}$ may have a substituent. The substituent is not particularly limited. As the substituent, a halogen atom, a hydroxyl group, an alkyl group (preferably a linear or branched alkyl group having 1 to 5 carbon atoms), or a halogenated alkyl group is preferable, a halogen atom or a halogenated alkyl group having 1 to 5 carbon atoms is more preferable, and a fluorine atom or a fluorinated alkyl group having 1 to 5 carbon atoms is particularly preferable. It is preferable that the aryl group has a fluorine atom from the viewpoint that the polarity of the anionic moiety is increased.

Among these, $R^{b01}$ to $R^{b04}$ in Formula (I1) each represent preferably a fluorinated phenyl group and particularly preferably a perfluorophenyl group.

Specific preferred examples of the anion moiety of the compound represented by Formula (I1) include tetrakis(pentafluorophenyl)borate ($[B(C_6F_5)_4]^-$); tetrakis[(trifluoromethyl)phenyl]borate ($[B(C_6H_4CF_3)_4]^-$); difluorobis(pentafluorophenyl)borate ($[(C_6F_5)_2BF_2]^-$); trifluoro(pentafluorophenyl)borate ($[(C_6F_5)BF_3]^-$); and tetrakis(difluorophenyl)borate ($[B(C_6H_3F_2)_4]^-$). Among these, tetrakis(pentafluorophenyl)borate ($[B(C_6F_5)_4]^-$) is particularly preferable.

· Cationic moiety

In Formula (I1), suitable examples of $Q^{q+}$ include a sulfonium cation and an iodonium cation, and organic cations each represented by General Formulae (ca-1) to (ca-5) are particularly preferable.

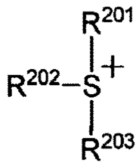

(ca-1)

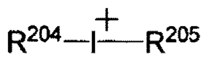

(ca-2)

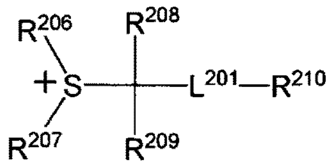

(ca-3)

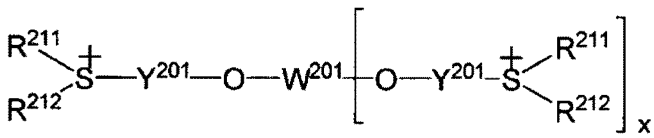

... (ca-4)

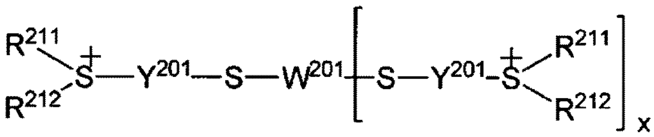

... (ca-5)

[In the formulae, $R^{201}$ to $R^{207}$, $R^{211}$, and $R^{212}$ each independently represent an aryl group, a heteroaryl group, an alkyl group, or an alkenyl group, which may have a substituent. $R^{201}$ to $R^{203}$, $R^{206}$ and $R^{207}$, and $R^{211}$ and $R^{212}$ may be bonded to each other to form a ring with the sulfur atom in the formulae. $R^{208}$ and $R^{209}$ each independently represent a hydrogen atom or an alkyl group having 1 to 5 carbon atoms. $R^{210}$ represents an aryl group which may have a substituent, an alkyl group which may have a substituent, an alkenyl group which may have a substituent, or a $-SO_2$-containing cyclic group which may have a substituent. $L^{201}$ represents -C(=O)- or -C(=O)-O-. $Y^{201}$'s each independently represent an arylene group, an alkylene group, or an alkenylene group. x represents 1 or 2. $W^{201}$ represents an (x + 1)-valent linking group.]

Examples of the aryl group as $R^{201}$ to $R^{207}$, $R^{211}$, and $R^{212}$ include an unsubstituted aryl group having 6 to 20 carbon atoms. Among the examples, a phenyl group or a naphthyl group is preferable.

Examples of the heteroaryl group as $R^{201}$ to $R^{207}$, $R^{211}$, and $R^{212}$ include those obtained by substituting some carbon atoms constituting the aryl group with heteroatoms. Examples of the heteroatoms include an oxygen atom, a sulfur atom, and a nitrogen atom. Examples of the heteroaryl group include a group in which one hydrogen atom has been removed from 9H-thioxanthene, and examples of the substituted heteroaryl group include a group in which one hydrogen atom has been removed from 9H-thioxanthene-9-one.

The alkyl group as $R^{201}$ to $R^{207}$, $R^{211}$, and $R^{212}$ is a chain-like or cyclic alkyl group, and the number of carbon atoms thereof is preferably in a range of 1 to 30.

It is preferable that the alkenyl group as $R^{201}$ to $R^{207}$, $R^{211}$, and $R^{212}$ has 2 to 10 carbon atoms.

Examples of the substituent which may be contained in $R^{201}$ to $R^{207}$ and $R^{210}$ to $R^{212}$ include an alkyl group,

a halogen atom, a halogenated alkyl group, a carbonyl group, a cyano group, an amino group, an oxo group (=O), an aryl group, and a group represented by any of General Formulae (ca-r-1) to (ca-r-10).

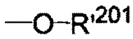 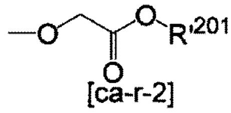 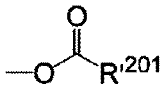

[ca-r-1] [ca-r-2] [ca-r-3]

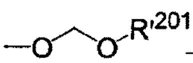 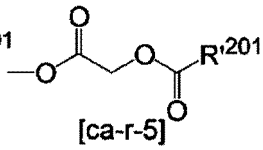 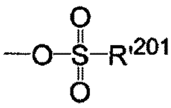 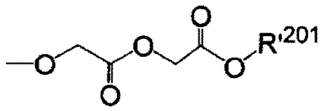

[ca-r-4] [ca-r-5] [ca-r-6] [ca-r-7]

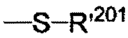 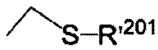 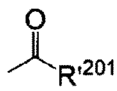

[ca-r-8] [ca-r-9] [ca-r-10]

[In the formulae, R'$^{201}$'s each independently represent a hydrogen atom, a cyclic group which may have a substituent, a chain-like alkyl group which may have a substituent, or a chain-like alkenyl group which may have a substituent.]

In Formulae (ca-r-1) to (ca-r-10), R'$^{201}$'s each independently represent a hydrogen atom, a cyclic group which may have a substituent, a chain-like alkyl group which may have a substituent, or a chain-like alkenyl group which may have a substituent.

Cyclic group which may have substituent:

The cyclic group is preferably a cyclic hydrocarbon group, and the cyclic hydrocarbon group may be an aromatic hydrocarbon group or a cyclic aliphatic hydrocarbon group. The aliphatic hydrocarbon group indicates a hydrocarbon group that has no aromaticity. Further, the aliphatic hydrocarbon group may be saturated or unsaturated. In general, it is preferable that the aliphatic hydrocarbon group is saturated.

The aromatic hydrocarbon group as R'$^{201}$ is a hydrocarbon group having an aromatic ring. The aromatic hydrocarbon group has preferably 3 to 30 carbon atoms, more preferably 5 to 30 carbon atoms, still more preferably 5 to 20 carbon atoms, particularly preferably 6 to 15 carbon atoms, and most preferably 6 to 10 carbon atoms. Here, the number of carbon atoms in a substituent is not included in the number of carbon atoms.

Specific examples of the aromatic ring of the aromatic hydrocarbon group as R'$^{201}$ include benzene, fluorene, naphthalene, anthracene, phenanthrene, biphenyl, an aromatic heterocyclic ring in which some carbon atoms constituting these aromatic rings have been substituted with heteroatoms, and a ring in which some hydrogen atoms constituting these aromatic rings or aromatic heterocyclic rings have been substituted with oxo groups. Examples of the heteroatom in the aromatic heterocyclic rings include an oxygen atom, a sulfur atom, and a nitrogen atom.

Specific examples of the aromatic hydrocarbon group as R'$^{201}$ include a group obtained by removing one hydrogen atom from the aromatic ring (an aryl group such as a phenyl group, a naphthyl group, or an anthracenyl group), a group in which one hydrogen atom of the aromatic ring has been substituted with an alkylene group (an arylalkyl group such as a benzyl group, a phenethyl group, a 1-naphthylmethyl group, a 2-naphthylmethyl group, a 1-naphthylethyl group, or a 2-naphthylethyl group), a group obtained by removing one hydrogen atom from a ring (such as anthraquinone) in which some hydrogen atoms constituting the aromatic ring have been substituted with an oxo group, and a group obtained by removing one hydrogen atom from an aromatic heterocyclic ring (such as 9H-thioxanthene or 9H-thioxanthene-9-one). The alkylene group (alkyl chain in the arylalkyl group) has preferably 1 to 4 carbon atoms, more preferably 1 or 2 carbon atoms, and particularly preferably 1 carbon atom.

Examples of the cyclic aliphatic hydrocarbon group as R'$^{201}$ include an aliphatic hydrocarbon group having a ring in the structure thereof.

Examples of the aliphatic hydrocarbon group having a ring in the structure thereof include an alicyclic hydrocarbon group (a group in which one hydrogen atom has been removed from an aliphatic hydrocarbon ring), a group in which the alicyclic hydrocarbon group is bonded to the terminal of a linear or branched aliphatic hydrocarbon group, and a group in which the alicyclic hydrocarbon group is interposed in the middle of a linear or branched aliphatic hydrocarbon group.

The number of carbon atoms in the alicyclic hydrocarbon group is preferably 3 to 20 and more preferably 3 to 12.

The alicyclic hydrocarbon group may be a polycyclic group or a monocyclic group. As the monocyclic alicyclic hydrocarbon group, a group in which one or more hydrogen atoms have been removed from a monocycloalkane is preferable. The monocycloalkane has preferably 3 to 6 carbon atoms, and specific examples thereof include cyclopentane and cyclohexane. As the polycyclic alicyclic hydrocarbon group, a group in which one or more hydrogen atoms have been removed from a polycycloalkane is preferable, and the number of carbon atoms of the polycycloalkane is preferably in a range of 7 to 30. Among these, a polycycloalkane having a crosslinked ring polycyclic skeleton such as adamantane, norbornane, isobornane, tricyclodecane, or tetracyclododecane; and a polycycloalkane having a fused ring polycyclic skeleton such as a cyclic group having a steroid skeleton are preferable as the polycycloalkane.

Among these examples, as the cyclic aliphatic hydrocarbon group as $R'^{201}$, a group in which one or more hydrogen atoms have been removed from a monocycloalkane or a polycycloalkane is preferable, a group in which one hydrogen atom has been removed from a polycycloalkane is more preferable, an adamantyl group or a norbornyl group is particularly preferable, and an adamantyl group is most preferable.

The number of carbon atoms in the linear or branched aliphatic hydrocarbon group which may be bonded to the alicyclic hydrocarbon group is preferably 1 to 10, more preferably 1 to 6, still more preferably 1 to 4, and most preferably 1 to 3.

As the linear aliphatic hydrocarbon group, a linear alkylene group is preferable, and specific examples thereof include a methylene group [$-CH_2-$], an ethylene group [$-(CH_2)_2-$], a trimethylene group [$-(CH_2)_3-$], a tetramethylene group [$-(CH_2)_4-$], and a pentamethylene group [$-(CH_2)_5-$].

As the branched aliphatic hydrocarbon group, a branched alkylene group is preferable, and specific examples thereof include alkylalkylene groups, for example, alkylmethylene groups such as $-CH(CH_3)-$, $-CH(CH_2CH_3)-$, $-C(CH_3)_2-$, $-C(CH_3)(CH_2CH_3)-$, $-C(CH_3)(CH_2CH_2CH_3)-$, and $-C(CH_2CH_3)_2-$; alkylethylene groups such as $-CH(CH_3)CH_2-$, $-CH(CH_3)CH(CH_3)-$, $-C(CH_3)_2CH_2-$, $-CH(CH_2CH_3)CH_2-$, and $-C(CH_2CH_3)_2-CH_2-$; alkyltrimethylene groups such as $-CH(CH_3)CH_2CH_2-$ and $-CH_2CH(CH_3)CH_2-$; and alkyltetramethylene groups such as $-CH(CH_3)CH_2CH_2CH_2-$ and $-CH_2CH(CH_3)CH_2CH_2-$. As the alkyl group in the alkylalkylene group, a linear alkyl group having 1 to 5 carbon atoms is preferable.

Chain-like alkyl group which may have substituent:

The chain-like alkyl group as $R'^{201}$ may be linear or branched.

The linear alkyl group has preferably 1 to 20 carbon atoms, more preferably 1 to 15 carbon atoms, and most preferably 1 to 10 carbon atoms. Specifically, a methyl group, an ethyl group, a propyl group, a butyl group, a pentyl group, a hexyl group, a heptyl group, an octyl group, a nonyl group, a decanyl group, an undecyl group, a dodecyl group, a tridecyl group, an isotridecyl group, a tetradecyl group, a pentadecyl group, a hexadecyl group, an isohexadecyl group, a heptadecyl group, an octadecyl group, a nonadecyl group, an icosyl group, a henicosyl group, and a docosyl group are exemplary examples.

The number of carbon atoms in the branched alkyl group is preferably 3 to 20, more preferably 3 to 15, and most preferably 3 to 10. Specific examples thereof include a 1-methylethyl group, a 1-methylpropyl group, a 2-methylpropyl group, a 1-methylbutyl group, a 2-methylbutyl group, a 3-methylbutyl group, a 1-ethylbutyl group, a 2-ethylbutyl group, a 1-methylpentyl group, a 2-methylpentyl group, a 3-methylpentyl group, and a 4-methylpentyl group.

Chain-like alkenyl group which may have substituent:

The chain-like alkenyl group as $R'^{201}$ may be linear or branched, and the number of carbon atoms thereof is preferably in a range of 2 to 10, more preferably in a range of 2 to 5, still more preferably in a range of 2 to 4, and particularly preferably 3. Examples of the linear alkenyl group include a vinyl group, a propenyl group (an allyl group), and a butynyl group. Examples of the branched alkenyl group include a 1-methylvinyl group, a 2-methylvinyl group, a 1-methylpropenyl group, and a 2-methylpropenyl group.

Among the examples, as the chain-like alkenyl group, a linear alkenyl group is preferable, a vinyl group or a propenyl group is more preferable, and a vinyl group is particularly preferable.

Examples of the substituent for the cyclic group, the chain-like alkyl group, or the chain-like alkenyl group as $R'^{201}$ include an alkoxy group, a halogen atom, a halogenated alkyl group, a hydroxyl group, a carbonyl group, a nitro group, an amino group, an oxo group, the cyclic group as $R'^{201}$, an alkylcarbonyl group, and a thienylcarbonyl group.

Among these, it is preferable that $R'^{201}$ represents a cyclic group which may have a substituent or a chin-like alkyl group which may have a substituent.

In a case where $R^{201}$ to $R^{203}$, $R^{206}$ and $R^{207}$, and $R^{211}$ and $R^{212}$ are bonded to each other to form a ring with a sulfur atom in the formulae, these groups may be bonded to each other via a heteroatom such as a sulfur atom, an oxygen atom, or a nitrogen atom, or a functional group such as a carbonyl group, $-SO-$, $-SO_2-$, $-SO_3-$, $-COO-$, $-CONH-$,

or - $N(R_N)$- ($R_N$ represents an alkyl group having 1 to 5 carbon atoms). As a ring to be formed, a ring containing the sulfur atom in the formula in the ring skeleton thereof is preferably a 3- to 10-membered ring and particularly preferably a 5- to 7-membered ring containing the sulfur atom. Specific examples of the ring to be formed include a thiophene ring, a thiazole ring, a benzothiophene ring, a thianthrene ring, a benzothiophene ring, a dibenzothiophene ring, a 9H-thioxanthene ring, a thioxanthone ring, a thianthrene ring, a phenoxathiin ring, a tetrahydrothiophenium ring, and a tetrahydrothiopyranium ring.

In Formula (ca-3), $R^{208}$ and $R^{209}$ each independently represent a hydrogen atom or an alkyl group having 1 to 5 carbon atoms and preferably a hydrogen atom or an alkyl group having 1 to 3 carbon atoms. In a case where $R^{208}$ and $R^{209}$ represent an alkyl group, $R^{208}$ and $R^{209}$ may be bonded to each other to form a ring.

In Formula (ca-3), $R^{210}$ represents an aryl group which may have a substituent, an alkyl group which may have a substituent, an alkenyl group which may have a substituent, or a -$SO_2$-containing cyclic group which may have a substituent.

Examples of the aryl group as $R^{210}$ include an unsubstituted aryl group having 6 to 20 carbon atoms. Among these, a phenyl group or a naphthyl group is preferable.

As the alkyl group as $R^{210}$, a chain-like or cyclic alkyl group having 1 to 30 carbon atoms is preferable.

It is preferable that the alkenyl group as $R^{210}$ has 2 to 10 carbon atoms.

In Formula (ca-4) and Formula (ca-5), $Y^{201}$'s each independently represent an arylene group, an alkylene group, or an alkenylene group.

Examples of the arylene group as $Y^{201}$ include groups obtained by removing one hydrogen atom from the aryl groups described as the aromatic hydrocarbon group as $R'^{201}$.

Examples of the alkylene group and alkenylene group as $Y^{201}$ include groups obtained by removing one hydrogen atom from the groups described as the chain-like alkyl group and the chain-like alkenyl group as $R'^{201}$,

In Formulae (ca-4) and (ca-5), x represents 1 or 2.

$W^{201}$ represents an (x + 1)-valent linking group, that is, a divalent or trivalent linking group.

As the divalent linking group as $W^{201}$, a divalent hydrocarbon group which may have a substituent is preferable, and the same groups as the divalent hydrocarbon group which may have a substituent, described in the section of "epoxy group-containing group" are preferable. The divalent linking group as $W^{201}$ may be any of linear, branched, or cyclic and is preferably cyclic. Among these, a group in which two carbonyl groups are combined at both ends of an arylene group, or a group consisting only of an arylene group is preferable. Examples of the arylene group include a phenylene group and a naphthylene group. Among these, a phenylene group is particularly preferable.

Examples of the trivalent linking group as $W^{201}$ include a group in which one hydrogen atom has been removed from the above-described divalent linking group as $W^{201}$ and a group obtained by bonding the divalent linking group to another divalent linking group described above. As the trivalent linking group as $W^{201}$, a group obtained by bonding two carbonyl groups to an arylene group is preferable.

Specific examples of suitable cations represented by Formula (ca-1) include cations represented by Formulae (ca-1-1) and (ca-1-24).

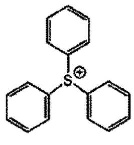
(ca-1-1)

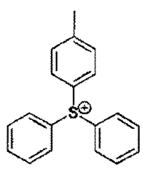
(ca-1-2)

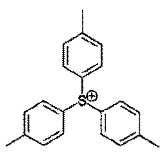
(ca-1-3)

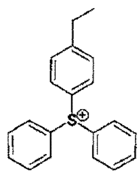
(ca-1-4)

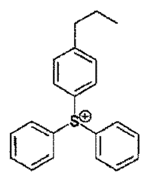
(ca-1-5)

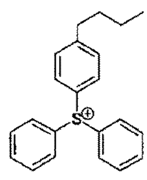
(ca-1-6)

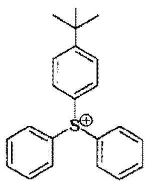
(ca-1-7)

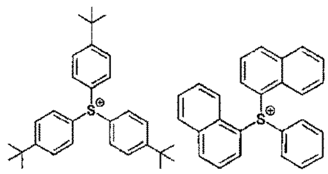
(ca-1-8) (ca-1-9)

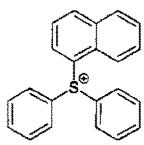
(ca-1-10)

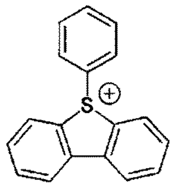

(ca-1-11)

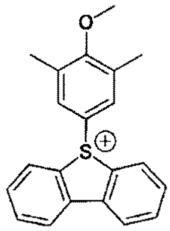

(ca-1-12)

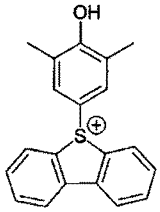

(ca-1-13)

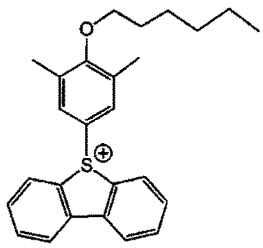

(ca-1-14)

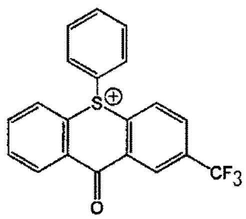

(ca-1-15)

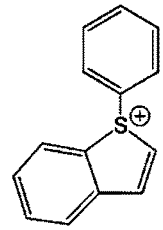

(ca-1-16)

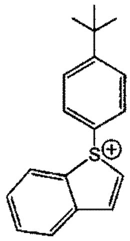

(ca-1-17)

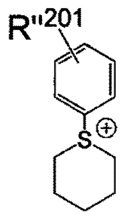

(ca-1-18)

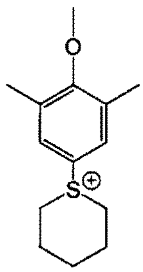

(ca-1-19)

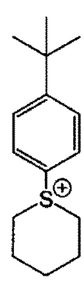

(ca-1-20)

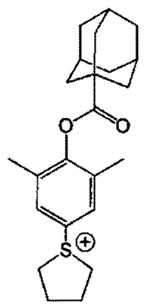

(ca-1-21)

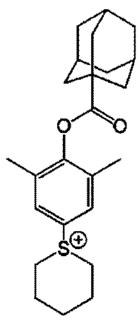

(ca-1-22)

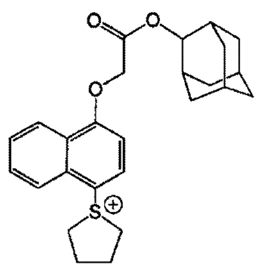

(ca-1-23)

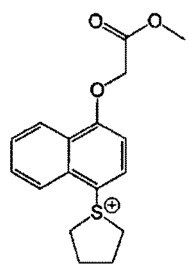

(ca-1-24)

[In the formulae, $R''^{201}$ represents a hydrogen atom or a substituent. Examples of the substituent include the same groups as the substituents which may be included in $R^{201}$ to $R^{207}$ and $R^{210}$ to $R^{212}$.]

Further, as the cation represented by Formula (ca-1), cations each represented by General Formulae (ca-1-25) to (ca-1-35) are also preferable.

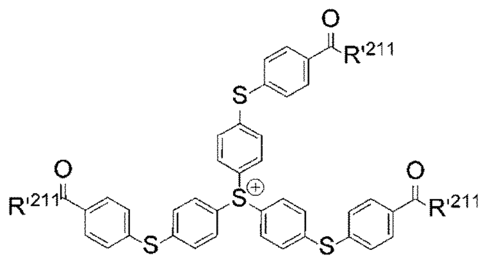

（ｃａ－１－２５）

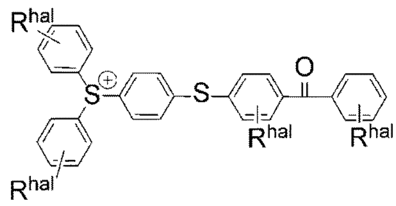

（ｃａ－１－２６）

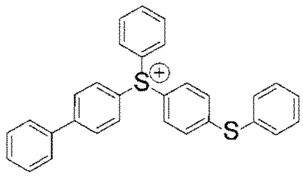

（ｃａ－１－２７）

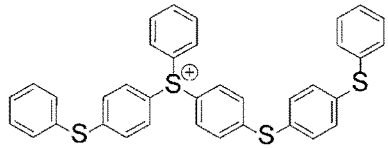

（ｃａ－１－２８）

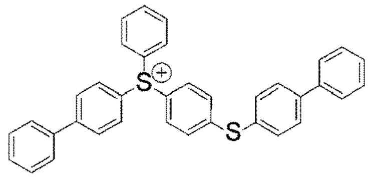

（ｃａ－１－２９）

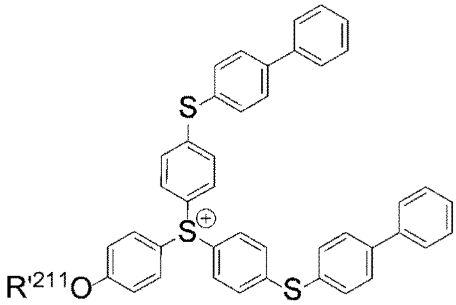

（ｃａ－１－３０）

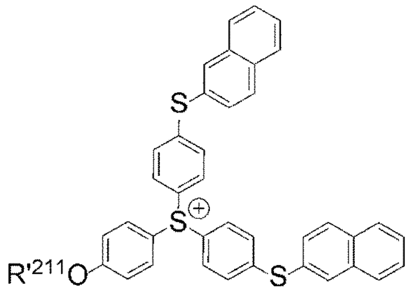

（ｃａ－１－３１）

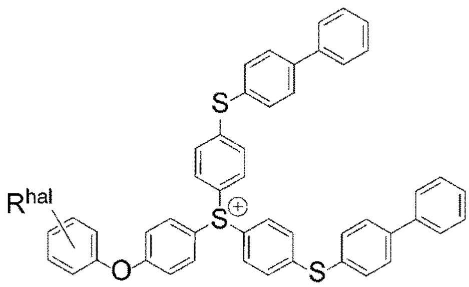

（ｃａ－１－３２）

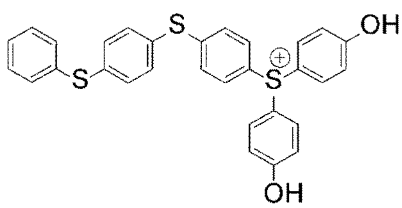

（ｃａ－１－３３）

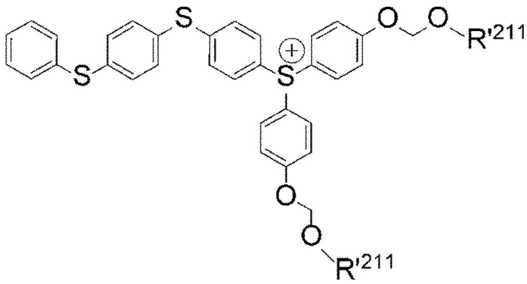

(ca-1-34)

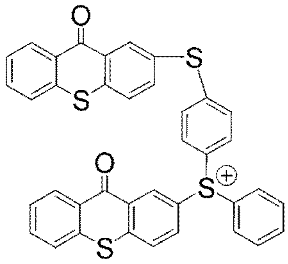

(ca-1-35)

[In the formulae, R'211 represents an alkyl group. $R^{hal}$ represents a hydrogen atom or a halogen atom.]

Further, as the cation represented by Formula (ca-1), cations represented by Chemical Formulae (ca-1-36) to (ca-1-48) are also preferable.

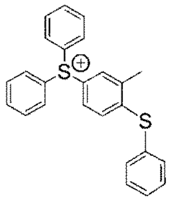

(ca-1-36)

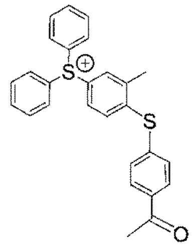

(ca-1-37)

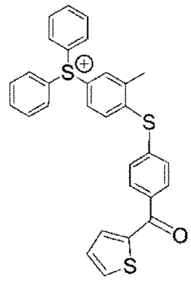

(ca-1-38)

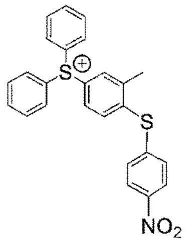

(ca-1-39)

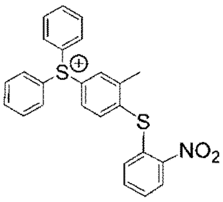

(ca-1-40)

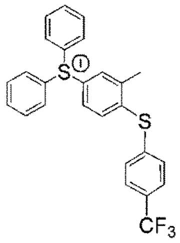

(ca-1-41)

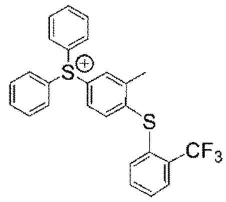

(ca-1-42)

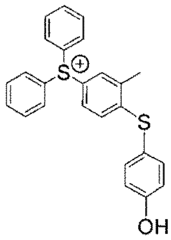

(ca-1-43)

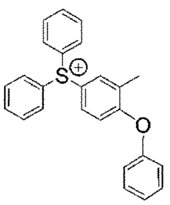

(ca-1-44)

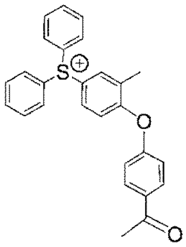

(ca-1-45)

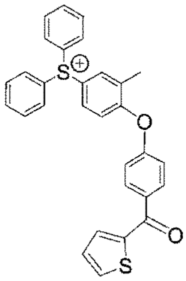

(ca-1-46)

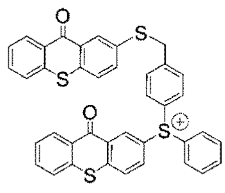

(ca-1-47)

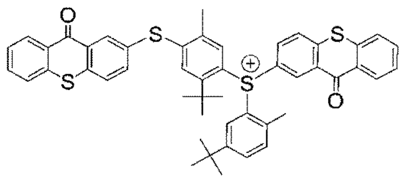

(ca−1−48)

Specific suitable examples of cations represented by Formula (ca-2) include a diphenyliodonium cation and a bis(4-tert-butylphenyl)iodonium cation.

Specific suitable examples of cations represented by Formula (ca-3) include cations each represented by Formulae (ca-3-1) to (ca-3-6).

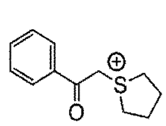 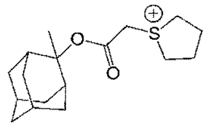 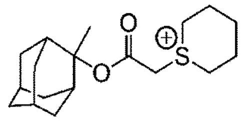 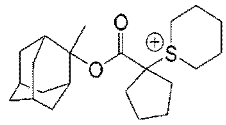

**(ca-3-1)** **(ca-3-2)** **(ca-3-3)** **(ca-3-4)**

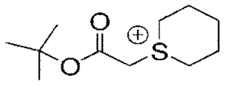 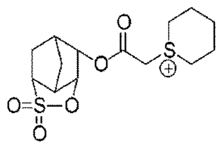

**(ca-3-5)** **(ca-3-6)**

Specific examples of suitable cations represented by Formula (ca-4) include cations each represented by Formulae (ca-4-1) and (ca-4-2).

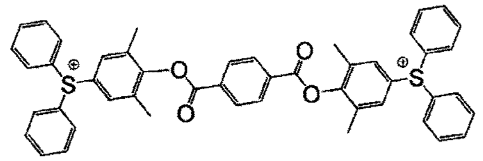 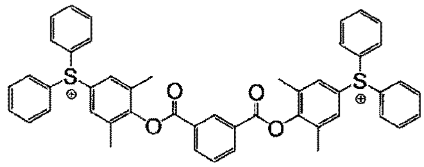

**(ca-4-1)** **(ca-4-2)**

Further, as the cation represented by Formula (ca-5), cations each represented by General Formulae (ca-5-1) to (ca-5-3) are also preferable.

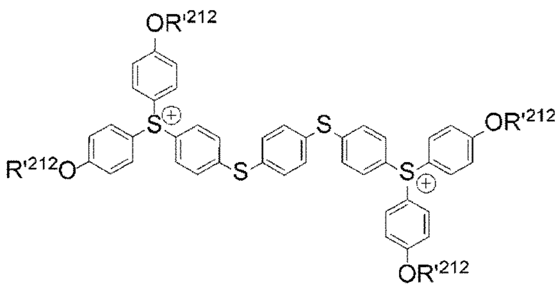

(ca−5−1)

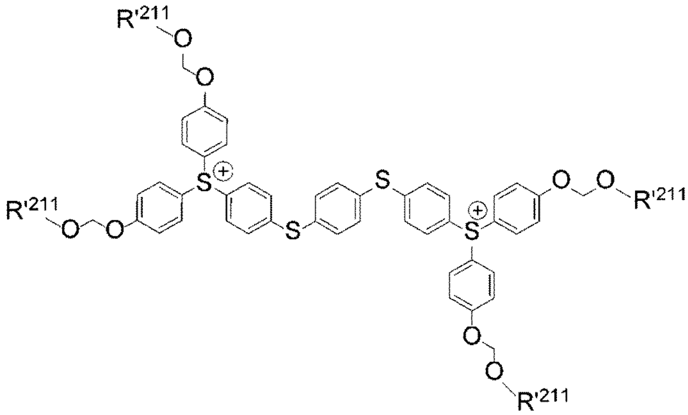

(ca-5-2)

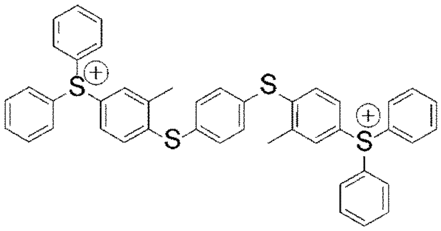

(ca-5-3)

[In the formulae, R'[212] represents an alkyl group or a hydrogen atom. R'[211] represents an alkyl group.]

Among the examples, as the cation moiety $[(Q^{q+})_{1/q}]$, a cation represented by General Formula (ca-1) is preferable, a cation represented by any of Formulae (ca-1-1) to (ca-1-48) is more preferable, and a cation represented by Formula (ca-1-25), a cation represented by Formula (ca-1-29), a cation represented by Formula (ca-1-35), a cation represented by Formula (ca-1-47), or a cation represented by Formula (ca-1-48) is still more preferable.

Specific examples of the suitable component (I1) are shown below.

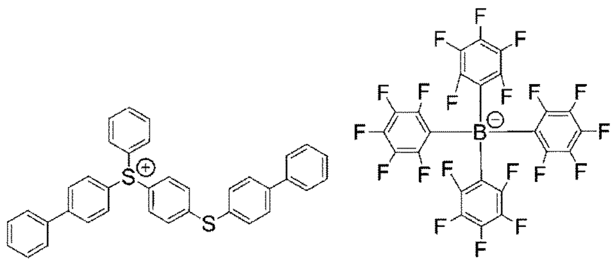

···(I1-1)

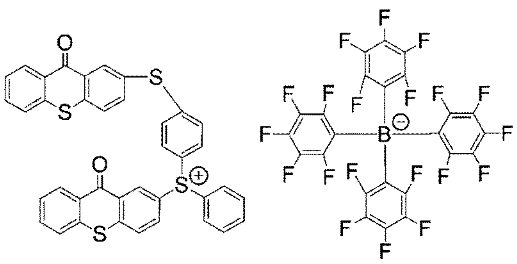

···(I1-2)

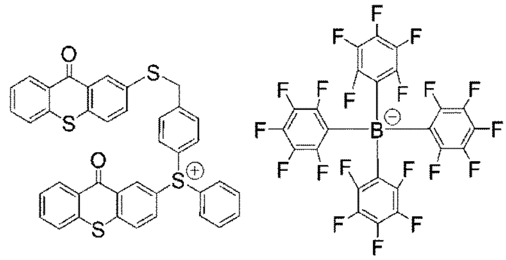

···(I 1−3)

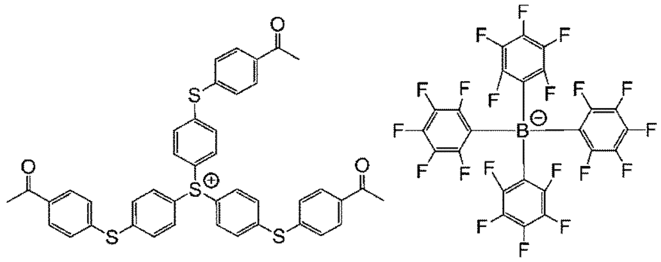

···(I 1−4)

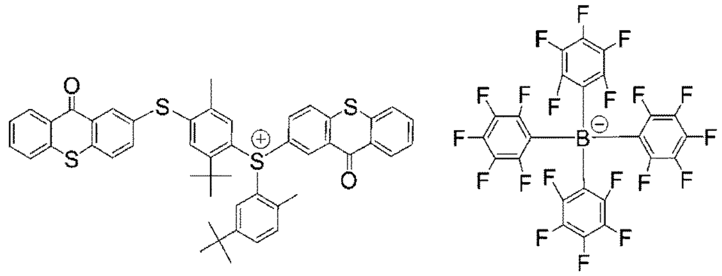

···(I 1−5)

<<Component (I2)>>

The component (I2) is a compound represented by General Formula (I2-1) or (I2-2).

Since a relatively strong acid is generated upon light exposure from the component (I2), in a case where a pattern is formed using the photocurable composition containing the component (I), the sensitivity can be sufficiently obtained, and thus a satisfactory pattern is formed.

$$P^{\ominus}\left(R^{b05}\right)_6 \quad \left(Q^{q\oplus}\right)_{1/q} \quad \cdots (I2-1)$$

[In Formula, $R^{b05}$ represents a fluorinated alkyl group which may have a substituent or a fluorine atom. A plurality of $R^{b05}$'s may be the same as or different from each other. q represents an integer of 1 or greater, and $Q^{q+}$ represents a q-valent organic cation.]

$$Sb^{\ominus}\left(R^{b06}\right)_6 \quad \left(Q^{q\oplus}\right)_{1/q} \quad \cdots (I2-2)$$

[In Formula, $R^{b06}$ represents a fluorinated alkyl group which may have a substituent or a fluorine atom. A plurality of $R^{b06}$'s may be the same as or different from each other. q represents an integer of 1 or greater, and $Q^{q+}$ represents a q-valent organic cation.]

. Anionic moiety

In Formula (I2-1), $R^{b05}$ represents a fluorinated alkyl group which may have a substituent or a fluorine atom. A plurality of $R^{b05}$'s may be the same as or different from each other.

The fluorinated alkyl group as $R^{b05}$ has preferably 1 to 10 carbon atoms, more preferably 1 to 8 carbon atoms,

and still more preferably 1 to 5 carbon atoms. Specific examples thereof include an alkyl group having 1 to 5 carbon atoms, in which some or all hydrogen atoms have been substituted with fluorine atoms.

Among the examples, $R^{b05}$ represents preferably a fluorine atom or a fluorinated alkyl group having 1 to 5 carbon atoms, more preferably a fluorine atom or a perfluoroalkyl group having 1 to 5 carbon atoms, and still more preferably a fluorine atom, a trifluoromethyl group, or a pentafluoroethyl group.

It is preferable that the anion moiety of the compound represented by Formula (I2-1) is an anion moiety represented by General Formula (b0-2a).

$$\left[\left(R^{bf05}\right)_{nb^1} PF_{(6-nb^1)}\right]^{\ominus} \qquad (b0-2a)$$

[In the formula, $R^{bf05}$ represents a fluorinated alkyl group which may have a substituent. $nb^1$ represents an integer of 1 to 5.]

In Formula (b0-2a), the fluorinated alkyl group which may have a substituent as $R^{bf05}$ has the same definition as the fluorinated alkyl group which may have a substituent, described in the section of $R^{b05}$.

In Formula (b0-2a), $nb^1$ represents preferably an integer of 1 to 4, more preferably an integer of 2 to 4, and most preferably 3.

In Formula (I2-2), $R^{b06}$ represents a fluorinated alkyl group which may have a substituent or a fluorine atom. A plurality of $R^{b06}$'s may be the same as or different from each other.

The fluorinated alkyl group as $R^{b06}$ has preferably 1 to 10 carbon atoms, more preferably 1 to 8 carbon atoms, and still more preferably 1 to 5 carbon atoms. Specific examples thereof include an alkyl group having 1 to 5 carbon atoms, in which some or all hydrogen atoms have been substituted with fluorine atoms.

Among these, $R^{b06}$ represents preferably a fluorine atom or a fluorinated alkyl group having 1 to 5 carbon atoms, more preferably a fluorine atom or a perfluoroalkyl group having 1 to 5 carbon atoms, and still more preferably a fluorine atom.

. Cationic moiety

In Formula (12-1) and Formula (I2-2), q represents an integer of 1 or greater, and $Q^{q+}$ represents a q-valent organic cation.

$Q^{q+}$ has the same definition as that for $Q^{q+}$ in Formula (I1). Among the examples, $Q^{q+}$ represents preferably a cation represented by General Formula (ca-1), more preferably a cation represented by any of Formulae (ca-1-1) to (ca-1-48), and still more preferably a cation represented by Formula (ca-1-25), a cation represented by Formula (ca-1-29), a cation represented by Formula (ca-1-35), or a cation represented by Formula (ca-1-47).

Specific suitable examples of the component (I2) are shown below.

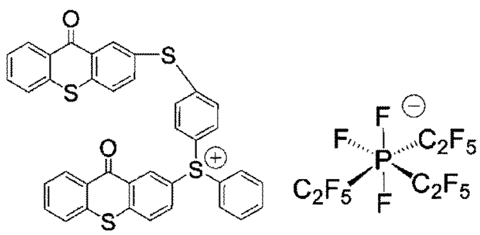

···(I2-1-1)

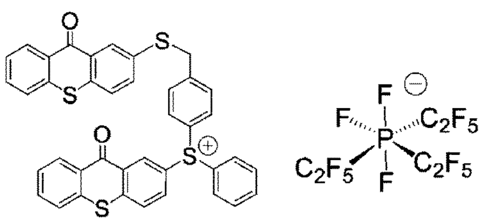

···(I2-1-2)

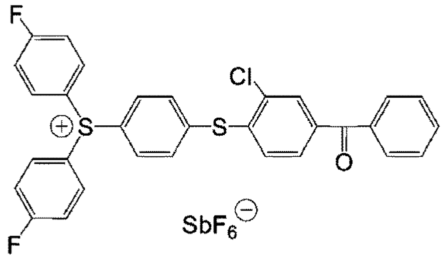

···(I 2—2—1)

<<Component (I3)>>

The component (I3) is a compound represented by General Formula (I3-1) or (I3-2).

$R^{b12}—SO_3^{\ominus}$ $(M^{m\oplus})_{1/m}$

(I 3—1)

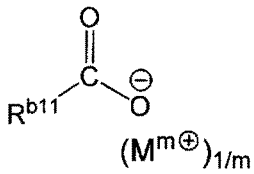

(I 3—2)

[In the formulae, $R^{b11}$ and $R^{b12}$ represent a cyclic group which may have a substituent other than a halogen atom, a chain-like alkyl group which may have a substituent other than a halogen atom, or a chain-like alkenyl group which may have a substituent other than a halogen atom. m represents an integer of 1 or greater, and $M^{m+}$'s each independently represent an m-valent organic cation.]

{Component (I3-1)}

. Anionic moiety

In Formula (I3-1), $R^{b12}$ represents a cyclic group which may have a substituent other than a halogen atom, a chain-like alkyl group which may have a substituent other than a halogen atom, or a chain-like alkenyl group which may have a substituent other than a halogen atom, and examples thereof include groups having no substituent or having a substituent other than a halogen atom among the cyclic group, the chain-like alkyl group, and the chain-like alkenyl group as $R'^{201}$ described above.

It is preferable that $R^{b12}$ represents a chain-like alkyl group which may have a substituent other than a halogen atom or an aliphatic cyclic group which may have a substituent other than a halogen atom.

The chain-like alkyl group has preferably 1 to 10 carbon atoms and more preferably 3 to 10 carbon atoms. As the aliphatic cyclic group, a group in which one or more hydrogen atoms have been removed from adamantane, norbornane, isobornane, tricyclodecane, or tetracyclododecane (a group which may have a substituent other than a halogen atom); and a group in which one or more hydrogen atoms have been removed from camphor are more preferable.

The hydrocarbon group as $R^{b12}$ may have a substituent other than a halogen atom, and examples of the substituent are the same as the substituents other than a halogen atom, which may be included in the hydrocarbon group (such as an aromatic hydrocarbon group, an aliphatic cyclic group, or a chain-like alkyl group) as $R^{b11}$ in Formula (I3-2).

Here, the expression of "may have a substituent other than a halogen atom" excludes not only a case of having a substituent consisting only of a halogen atom, but also a case of having a substituent having even one halogen atom (for example, a case where the substituent is a fluorinated alkyl group).

Specific preferred examples of the anion moiety of the component (I3-1) are shown below.

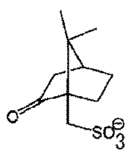 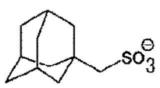 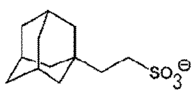 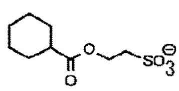 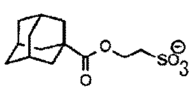

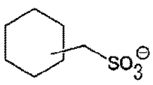 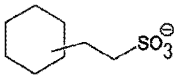 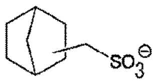 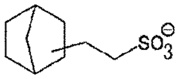

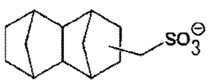 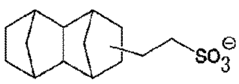 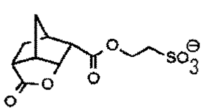

$H_3C{-}SO_3^{\ominus}$ 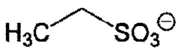 $C_aH_{2a+1}SO_3^-$ (a=3~10)

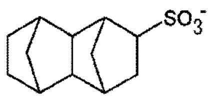 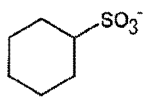 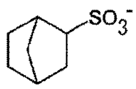

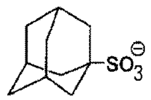 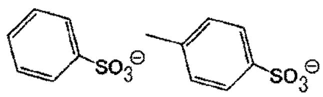

· Cationic moiety

In Formula (I3-1), $M^{m+}$ represents an m-valent organic cation.

Suitable examples of the organic cation as $M^{m+}$ are the same as the cations each represented by Formulae (ca-1) to (ca-5). Among these, a cation represented by the Formula (ca-1) is more preferable. In addition, a sulfonium cation in which at least one of $R^{201}$, $R^{202}$, and $R^{203}$ in General Formula (ca-1) represents an organic group (such as an aryl group, a heteroaryl group, an alkyl group, or an alkenyl group) which may have a substituent and has 16 or more carbon atoms is particularly preferable from the viewpoint of improving resolution and roughness characteristics.

The substituent that the organic group may have is as described above, and examples thereof include an alkyl group, a halogen atom, a halogenated alkyl group, a carbonyl group, a cyano group, an amino group, an oxo group (=O), an aryl group, and groups represented by Formulae (ca-r-1) to (ca-r-10).

The number of carbon atoms in the above-described organic group (such as an aryl group, a heteroaryl group, an alkyl group, and an alkenyl group) is preferably in a range of 16 to 25, more preferably in a range of 16 to 20, and particularly preferably in a range of 16 to 18. Suitable examples of the organic cation as $M^{m+}$ include cations each represented by Formulae (ca-1-25), (ca-1-26), (ca-1-28) to (ca-1-36), (ca-1-38), (ca-1-46), and (ca-1-47), and among these, a cation represented by Formula (ca-1-29) is particularly preferable.

{Component (I3-2)}

· Anionic moiety

In Formula (I3-2), $R^{b11}$ represents a cyclic group which may have a substituent other than a halogen atom, a chain-like alkyl group which may have a substituent other than a halogen atom, or a chain-like alkenyl group which may have a substituent other than a halogen atom, and examples thereof include groups having no substituent or having a substituent other than a halogen atom among the cyclic group, the chain-like alkyl group, and the chain-like alkenyl group described in the section of $R'^{201}$ above.

Among these, it is preferable that $R^{b11}$ represents an aromatic hydrocarbon group which may have a substituent other than a halogen atom, an aliphatic cyclic group which may have a substituent other than a halogen atom, and a chain-like alkyl group which may have a substituent other than a halogen atom. Examples of the substituents that these groups may have include a hydroxyl group, an oxo group, an alkyl group, an aryl group, a lactone-containing cyclic group, an ether bond, an ester bond, and a combination thereof.

In a case where the above-described groups have an ether bond or an ester bond as the substituent, the groups may have an ether bond or an ester bond via an alkylene group, and a linking group represented by any of General Formulae (y-al-1) to (y-al-7) is preferable as the substituent in this case.

Further, in General Formulae (y-al-1) to (y-al-7), $V'^{101}$ in General Formulae (y-al-1) to (y-al-7) is bonded to $R^{b11}$

of Formula (I3-2).

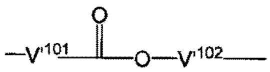 (y-al-1) 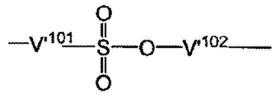 (y-al-6)

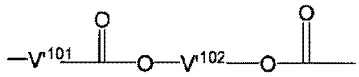 (y-al-2) 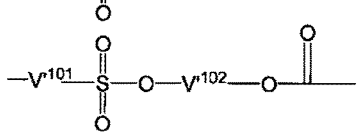 (y-al-7)

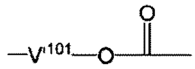 (y-al-3)

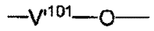 (y-al-4)

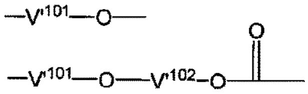 (y-al-5)

[In the formulae, $V'^{101}$ represents a single bond or an alkylene group having 1 to 5 carbon atoms. $V'^{102}$ represents a divalent saturated hydrocarbon group having 1 to 30 carbon atoms.]

As the divalent saturated hydrocarbon group as $V'^{102}$, an alkylene group having 1 to 30 carbon atoms is preferable, an alkylene group having 1 to 10 carbon atoms is more preferable, and an alkylene group having 1 to 5 carbon atoms is still more preferable.

The alkylene group as $V'^{101}$ and $V'^{102}$ may be a linear alkylene group or a branched alkylene group, and a linear alkylene group is preferable.

Specific examples of the alkylene group as $V'^{101}$ and $V'^{102}$ include a methylene group [$-CH_2-$]; an alkylmethylene group such as $-CH(CH_3)-$, $-CH(CH_2CH_3)-$, $-C(CH_3)_2-$, $-C(CH_3)(CH_2CH_3)-$, $-C(CH_3)(CH_2CH_2CH_3)-$, or $-C(CH_2CH_3)_2-$; an ethylene group [$-CH_2CH_2-$]; an alkylethylene group such as $-CH(CH_3)CH_2-$, $-CH(CH_3)CH(CH_3)-$, $-C(CH_3)_2CH_2-$, or $-CH(CH_2CH_3)CH_2-$; a trimethylene group (n-propylene group) [$-CH_2CH_2CH_2-$]; an alkyltrimethylene group such as $-CH(CH_3)CH_2CH_2-$ or $-CH_2CH(CH_3)CH_2-$; a tetramethylene group [$-CH_2CH_2CH_2CH_2-$]; an alkyltetramethylene group such as $-CH(CH_3)CH_2CH_2CH_2-$ or $-CH_2CH(CH_3)CH_2CH_2-$; and a pentamethylene group [$-CH_2CH_2CH_2CH_2CH_2-$].

Further, some methylene groups in the alkylene groups as $V'^{101}$ and $V'^{102}$ may be substituted with a divalent aliphatic cyclic group having 5 to 10 carbon atoms. As the aliphatic cyclic group, a divalent group in which one hydrogen atom has been further removed from the cyclic aliphatic hydrocarbon group (a monocyclic alicyclic hydrocarbon group or a polycyclic alicyclic hydrocarbon group) as $R'^{201}$ is preferable, and a cyclohexylene group, a 1,5-adamantylene group, or a 2,6-adamantylene group is more preferable.

A phenyl group or a naphthyl group is more preferable as the aromatic hydrocarbon group.

As the aliphatic cyclic group, a group formed by removing one or more hydrogen atoms from a polycycloalkane such as adamantane, norbornane, isobornane, tricyclodecane, and tetracyclododecane is more preferable.

It is preferable that the chain-like alkyl group has 1 to 10 carbon atoms, and specific examples thereof include a linear alkyl group such as a methyl group, an ethyl group, a propyl group, a butyl group, a pentyl group, a hexyl group, a heptyl group, an octyl group, a nonyl group, or a decyl group; and a branched alkyl group such as a 1-methylethyl group, a 1-methylpropyl group, a 2-methylpropyl group, a 1-methylbutyl group, a 2-methylbutyl group, a 3-methylbutyl group, a 1-ethylbutyl group, a 2-ethylbutyl group, a 1-methylpentyl group, a 2-methylpentyl group, a 3-methylpentyl group, or a 4-methylpentyl group.

It is preferable that $R^{b11}$ represents a cyclic group which may have a substituent other than a halogen atom.

Specific preferred examples of the anion moiety of the component (I3-2) are shown below.

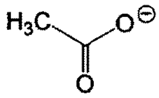 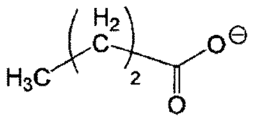 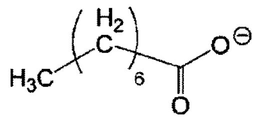

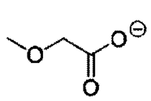 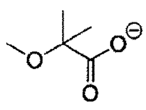 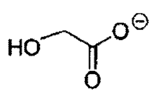 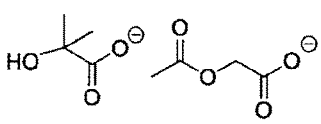

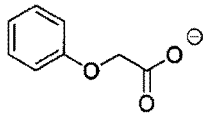 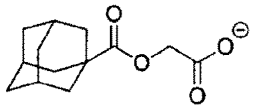 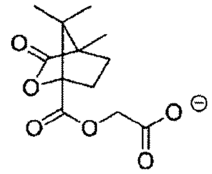

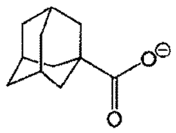 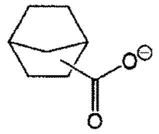 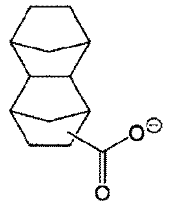 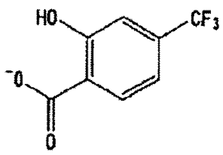

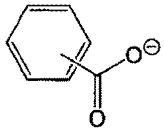 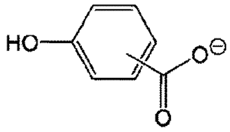 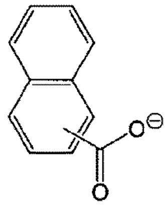 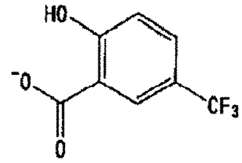

· Cationic moiety

In Formula (I3-2), $M^{m+}$ represents an m-valent organic cation and has the same definition as that for $M^{m+}$ in Formula (13-1).

From the viewpoint of high elasticity of a resin film and ease of forming a fine structure without residues, it is preferable that the component (I) is a cationic polymerization initiator which generates an acid having a pKa (acid dissociation constant) of -5 or less upon light exposure. It is possible to obtain high sensitivity to light exposure by using a cationic polymerization initiator which generates an acid having a pKa of more preferably -6 or less and still more preferably -8 or less. The lower limit of the pKa of the acid generated from the component (I) is preferably -15 or greater. The sensitivity is likely to be increased by using a cationic polymerization initiator which generates an acid having a pKa in the above-described suitable ranges.

Here, the term "pKa (acid dissociation constant)" is an index that has been typically used to show the acid strength of a target substance. Further, the pKa in the present specification is a value under a temperature condition of 25°C. Further, the pKa value can be acquired by performing measurement using a known method. In addition, calculated values using known software such as "ACD/Labs" (trade name, manufactured by Advanced Chemistry Development, Inc.) can also be used.

Specific suitable examples of the component (I3) are shown below.

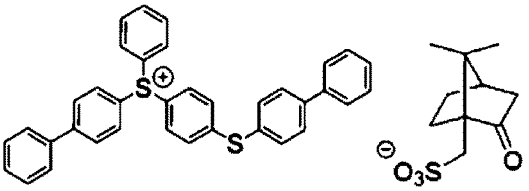 · · · (I 3－1－1)

The component (I) may be used alone or in combination of two or more kinds thereof.

In the photocurable composition according to the present embodiment, the component (I) includes preferably at least one selected from the group consisting of the component (I1), the component (I2), and the component (I3) and more preferably at least one selected from the group consisting of the component (I1) and the component (I2).

The content of the component (I) in the photocurable composition according to the present embodiment is preferably in a range of 0.05 to 10 parts by mass, more preferably in a range of 0.1 to 5 parts by mass, and still more preferably in a range of 0.2 to 3 parts by mass with respect to the total content (100 parts by mass) of the component (AC) and the component (A).

In a case where the content of the component (I) is greater than or equal to the lower limits of the above-described preferable ranges, the sensitivity can be sufficiently obtained, and lithography characteristics of the resist pattern are further improved. In addition, the hardness of the resin cured film is further increased. Meanwhile, in a case where the content thereof is less than or equal to the upper limits of the above-described preferable ranges, the sensitivity is moderately controlled, and a resist pattern having a satisfactory shape is likely to be obtained.

<Optional components>

The photocurable composition according to the present embodiment may contain other components as necessary, in addition to the component (AC), the component (A), and the component (I) described above.

In the photocurable composition according to the embodiment, as desired, miscible additives such as a metal oxide (M), a sensitizer component, a solvent, an additive resin for improving the performance of a film, a dissolution inhibitor, a basic compound, a plasticizer, a stabilizer, a colorant, and a halation-preventing agent can be added to the composition so that the composition contain such additives.

<<Metal oxide (M)>>

The photocurable composition according to the present embodiment may contain a metal oxide (M) (hereinafter, also referred to as "component (M)") in addition to the component (AC), the component (A), and the component (I) from the viewpoint that a cured film with increased hardness is likely to be obtained. Further, in a case where the photocurable composition contains the component (M) in combination with other components, a high-resolution pattern having a satisfactory shape can be formed.

Examples of the component (M) include oxides of metals such as silicon (metallic silicon), titanium, zirconium, and hafnium. Among these, an oxide of silicon is preferable, and silica is particularly preferable.

Further, the shape of the component (M) is preferably particulate. As such a particulate component (M), a component consisting of a group of particles having a volume average particle diameter of 5 to 40 nm is preferable, a component consisting of a group of particles having a volume average particle diameter of 5 to 30 nm is more preferable, and a component consisting of a group of particles having a volume average particle diameter of 10 to 20 nm is still more preferable.

<<Sensitizer component>>

The photocurable composition according to the present embodiment may further contain a sensitizer component.

The sensitizer component is not particularly limited as long as the sensitizer component can absorb energy upon light exposure and transmit the energy to other substances.

Specific examples of the sensitizer component include a benzophenone-based photosensitizer such as benzophenone or p,p'-tetramethyldiaminobenzophenone, a carbazole-based photosensitizer, an acetophene-based photosensitizer, a naphthalene-based photosensitizer such as 1,5-dihydroxynaphthalene, a phenol-based photosensitizer, an anthracene-based photosensitizer such as 9-ethoxyanthracene, and a known photosensitizer such as biacetyl, eosine, rose bengal, pyrene, phenothiazine, or anthrone.

< < Solvent> >

The photocurable composition according to the present embodiment may further contain a solvent (hereinafter, also referred to as "component (S)").

Examples of the component (S) include lactones such as γ-butyrolactone; ketones such as acetone, methyl ethyl ketone (MEK), cyclohexanone, methyl-n-pentyl ketone, methyl isopentyl ketone, and 2-heptanone; polyhydric alcohols such as ethylene glycol, diethylene glycol, propylene glycol, and dipropylene glycol; compounds having an ester bond, such as 2-methoxy butyl acetate, 3-methoxy butyl acetate, 4-methoxy butyl acetate, ethylene glycol monoacetate, diethylene glycol monoacetate, propylene glycol monoacetate, and dipropylene glycol monoacetate; polyhydric alcohol derivatives of compounds having an ether bond such as monoalkyl ether or monophenyl ether, such as monomethyl ether, monoethyl ether, monopropyl ether, or monobutyl ether of polyhydric alcohols or compounds having an ester bond [among these, propylene glycol monomethyl ether acetate (PGMEA) and propylene glycol monomethyl ether (PGME) are preferable]; cyclic ethers such as dioxane; esters such as methyl lactate, ethyl lactate (EL), methyl acetate, ethyl acetate, butyl acetate, methyl pyruvate, ethyl pyruvate, methyl methoxypropionate, and ethyl ethoxypropionate; aromatic organic solvents such as anisole, ethylbenzylether, cresylmethylether, diphenylether, dibenzylether, phenetole, butylphenylether, ethylbenzene, diethylbenzene, pentylbenzene, isopropylbenzene, toluene, xylene, cymene, and mesitylene; and dimethylsulfoxide (DMSO).

The component (S) may be used alone or in the form of a mixed solvent obtained by mixing two or more kinds thereof.

In a case where the photocurable composition contains the component (S), the amount thereof to be used is not particularly limited, and is appropriately set according to the thickness of the coating film at a concentration at which the substrate or the like can be coated with the photocurable composition without dripping.

For example, the component (S) can be used so that the solid content concentration is set to 50% by mass or greater, or the component (S) can be used so that the solid content concentration is set to 60% by mass or greater.

Further, an aspect in which the photocurable composition does not substantially contain the component (S) (that is, an aspect in which the solid content concentration is 100% by mass) can also be employed.

The viscosity of the photocurable composition according to the present embodiment at 23°C is, for example, in a range of 10 to 5,000 mPa s, and may be in a range of 30 to 3,000 mPa s or in a range of 50 to 2,000 mPa s.

The photocurable composition according to the present embodiment described above contains the acrylic resin (AC), the epoxy group-containing compound (A), and the cationic polymerization initiator (I). As such a component (AC), a component having a glass transition point of 0°C or lower is employed. In this manner, reforming of the cured film is promoted, and thus the adhesiveness of the cured film to an object is increased. In addition, as such a component (AC), a component having the constitutional unit (ac1) derived from an epoxy group-containing acrylic monomer in a specific content proportion (greater than 0% by mass and less than 50% by mass) is employed. In this manner, since the component (AC) and the component (A) are crosslinked in a well-balanced manner upon light exposure, peeling due to a chemical treatment with a solvent or the like is suppressed, and thus the chemical resistance is enhanced.

Further, according to the photocurable composition of the present embodiment, a high-resolution pattern can be formed in a satisfactory shape in the pattern formation, and the lithography characteristics can be improved.

The photocurable composition according to the present embodiment is useful as a photocurable adhesive material used in the production of electronic components (for example, MEMS, biotechnology, and the like) which are required to have various characteristics such as the balance between the adhesiveness and the chemical resistance.

(Method for forming pattern)

A method for forming a pattern according to the present embodiment includes a step of forming a photocurable film on a support (hereinafter, referred to as "film formation step") using the photocurable composition according to the embodiment described above, a step of exposing the photocurable film to light (hereinafter, referred to as "exposure step"), and a step of developing the exposed photocurable film, with a developing solution containing an organic solvent, to form a negative tone pattern (hereinafter, referred to as "development step").

For example, the method for forming a pattern according to the present embodiment can be performed in the following manner.

[Film formation step]

First, a photocurable film is formed by coating a support with the photocurable composition according to the embodiment using a known method such as a spin coating method, a roll coating method, or a screen printing method and by performing a bake (post apply bake (PAB)) treatment, for example, under a temperature condition of 50°C to 150°C for 2 to 60 minutes.

The support is not particularly limited and a known support of the related art can be used, and examples thereof include a substrate for an electronic component and a substrate on which a predetermined wiring pattern has been formed. More specific examples thereof include a metal substrate such as silicon, silicon nitride, titanium, tantalum, lithium tantalate ($LiTaO_3$), niobium, lithium niobate ($LiNbO_3$), palladium, titanium tungsten, copper, chromium, iron, or aluminum, and a glass substrate.

As the materials of the wiring pattern, copper, aluminum, nickel, or gold can be used.

A film thickness of the photocurable film to be formed of the photocurable composition is not particularly limited, but is preferably in a range of 10 to 50 $\mu$m.

[Exposure step]

Next, the formed photocurable film is selectively exposed using a known exposure device by being exposed through a mask (mask pattern) on which a predetermined pattern has been formed or by being irradiated directly with electron beams without a mask pattern for drawing or the like.

After the selective exposure is performed, a bake (post exposure bake (PEB)) treatment is performed as necessary, for example, under a temperature condition of 80°C to 150°C for 40 to 1,200 seconds, preferably 40 to 1,000 seconds, and more preferably 60 to 900 seconds.

The wavelength used for the exposure is not particularly limited, and radiation such as ultraviolet rays having a wavelength of 300 to 500 nm, g-line, h-line, i-line (wavelength of 365 nm), or visible rays is used for selective irradiation (exposure).

A low-pressure mercury lamp, a high-pressure mercury lamp, an ultra-high pressure mercury lamp, a metal halide lamp, an argon gas laser, or the like can be used as a source of the radiation described above.

The radiation here denotes ultraviolet rays, visible rays, far ultraviolet rays, X-rays, electron beams, or the like. The irradiation amount of radiation varies depending on the kind of each component in the composition, the blending amount thereof, the film thickness of the coating film, and the like. For example, in a case where an ultra-high pressure mercury lamp is used, the irradiation amount thereof is in a range of 100 to 2,000 $mJ/cm^2$.

The photocurable film may be exposed through typical exposure (dry exposure) performed in air or an inert gas such as nitrogen or through liquid immersion exposure (liquid immersion lithography).

The photocurable film after the exposure step is highly transparent, and, for example, the haze value in a case of irradiation with i-line (wavelength of 365 nm) is preferably 3% or less and more preferably in a range of 1.0% to 2.7%.

The haze value of the photocurable film after the exposure step is measured using a method in conformity with JIS K 7136 (2000).

[Development step]

Next, the above-described exposed photocurable film is developed with a developing solution (organic developing solution) containing an organic solvent. After the development, it is preferable to perform a rinse treatment. A bake treatment (post bake) may be performed as necessary.

The organic solvent contained in the organic developing solution may be obtained by dissolving the component (A) and the component (AC) before exposure and can be appropriately selected from known organic solvents. Specific examples thereof include a polar solvent such as a ketone-based solvent, an ester-based solvent, an alcohol-based solvent, a nitrile-based solvent, an amide-based solvent, and an ether-based solvent, and a hydrocarbon-based solvent.

Examples of the ketone-based solvent include 1-octanone, 2-octanone, 1-nonanone, 2-nonanone, acetone, 4-heptanone, 1-hexanone, 2-hexanone, diisobutyl ketone, cyclohexanone, methylcyclohexanone, phenylacetone, methyl ethyl ketone, methyl isobutyl ketone, acetylacetone, acetonylacetone, ionone, diacetonylalcohol, acetylcarbinol, acetophenone, methyl naphthyl ketone, isophorone, propylenecarbonate, γ -butyrolactone, and methyl amyl ketone (2-heptanone). Among the examples, methyl amyl ketone (2-heptanone) is preferable as the ketone-based solvent.

Examples of the ester-based solvent include methyl acetate, butyl acetate, ethyl acetate, isopropyl acetate, amyl acetate, isoamyl acetate, ethyl methoxyacetate, ethyl ethoxy acetate, propylene glycol monomethyl ether acetate (PGMEA), ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Among these, butyl acetate or PGMEA is preferable as the ester-based solvent.

Examples of the nitrile-based solvent include acetonitrile, propionitrile, valeronitrile, and butyronitrile.

Known additives can be blended into the organic developing solution as necessary. Examples of the additive include a surfactant. The surfactant is not particularly limited, and for example, an ionic or non-ionic fluorine-based and/or silicon-based surfactant can be used.

As the surfactant, a non-ionic surfactant is preferable, and a non-ionic fluorine-based surfactant or a non-ionic silicon-based surfactant is more preferable.

In a case where a surfactant is blended into the solution, the amount of the surfactant to be blended is typically in a range of 0.001% to 5% by mass, preferably in a range of 0.005% to 2% by mass, and more preferably in a range of 0.01% to 0.5% by mass with respect to the total amount of the organic developing solution.

The developing treatment can be performed by a known developing method, and examples thereof include a method of immersing a support in a developing solution for a certain time (a dip method), a method of raising a developing solution on the surface of a support using the surface tension and maintaining the state for a certain time (a puddle

method), a method of spraying a developing solution to the surface of a support (spray method), and a method of continuously ejecting a developing solution onto a support rotating at a certain rate while scanning a developing solution ejection nozzle at a certain rate (dynamic dispense method).

The rinse treatment carried out using a rinse solution (washing treatment) can be performed according to a known rinse method. Examples of the method of performing the rinse treatment include a method of continuously ejecting a rinse solution onto a support rotating at a certain rate (rotary coating method), a method of immersing a support in a rinse solution for a certain time (dip method), and a method of spraying a rinse solution to the surface of a support (spray method).

It is preferable that the rinse treatment is performed with a rinse solution containing an organic solvent.

A pattern can be formed by performing the film formation step, the exposure step, and the development step described above.

In the method for forming a pattern according to the embodiment described above, since the photocurable composition according to the embodiment described above is used, a resin pattern in which peeling due to a chemical treatment with a solvent or the like is suppressed and which has enhanced chemical resistance can be formed. Further, in the pattern formation, the resolution is high, a resin pattern having a satisfactory shape is formed, and the lithography characteristics are excellent.

(Cured film)

The cured film according to the present embodiment is obtained by curing the above-described photocurable composition according to the embodiment.

(Cured film production method)

The method of producing a cured film according to the present embodiment includes a step (i) of forming a photocurable film on a support using the above-described photocurable composition according to the embodiment and a step (ii) of curing the photocurable film to obtain a cured film.

The operation of the step (i) can be performed in the same manner as in the section of [film formation step] described above. The bake treatment can be performed, for example, under a temperature condition of 80°C to 150°C for 40 to 600 seconds.

The curing treatment in the step (ii) can be performed, for example, under the conditions of a temperature of 100°C to 250°C for 0.5 to 2 hours.

The cured film production method according to the embodiment may include other steps in addition to the step (i) and the step (ii). For example, [exposure step] described above may be performed between the step (i) and the step (ii), and a cured film can also be obtained by selectively exposing the photocurable film formed in the step (i) and curing the photocurable film (pre-cured film) to which a bake (PEB) treatment has been performed as necessary.

According to the method of producing a cured film according to the embodiment described above, since the above-described photocurable composition according to the embodiment is used, a cured film with increased adhesiveness to an electronic component such as a silicon chip serving as an object can be produced.

[Examples]

Hereinafter, the present invention will be described in more detail with reference to examples, but the present invention is not limited to the following examples.

<Production of acrylic resin>

Each of acrylic resins (AC)-1 to (AC)-14 was obtained by performing known radical polymerization using "monomer from which constitutional unit is derived" listed in Table 1.

Table 1 shows the proportion of each constitutional unit constituting an acrylic resin, and the glass transition point Tg (°C) of the acrylic resin, the content proportion (% by mass) of the constitutional unit (ac1) in the acrylic resin, and the weight-average molecular weight Mw of the acrylic resin as characteristics of the acrylic resin.

The glass transition point of an acrylic resin was calculated by the following equation.

$$1/(Tg + 273) = \{W1/(Tg1 + 273) + W2/(Tg2 + 273) + ...\}/100$$

Tg: glass transition point (°C) of copolymer which is acrylic resin

Tg1: glass transition point (°C) of homopolymer having repeating structure of constitutional unit (1) derived from monomer (1)
Tg2: glass transition point (°C) of homopolymer having repeating structure of constitutional unit (2) derived from monomer (2)
W1: proportion (% by mass) of constitutional unit (1) constituting acrylic resin
W2: proportion (% by mass) of constitutional unit (2) constituting acrylic resin

$$W1 + W2 + ... = 100$$

The values disclosed in the (Kaji Test Research) homepage (www.kaji-tr.com) (KTR Corporation), Polymer Material Handbook (edited by The Society of Polymer Science, CRONA PUBLISHING CO., LTD., first edition, published on February 20, 1973), the acrylic product catalog (KYOEISHA CHEMICAL Co., Ltd.), and Polymer Data Handbook Basic Edition (edited by The Society of Polymer Science, BAIFUKAN CO., LTD., published on January 30, 1986) were employed as the glass transition point of the homopolymer.

For example, the glass transition point Tg (°C) of the acrylic resin (AC)-2 was calculated as follows.

The acrylic resin (AC)-2 is a copolymer of a constitutional unit derived from 2-methoxyethyl acrylate and a constitutional unit derived from n-butyl acrylate.

In a case where 2-methoxyethyl acrylate is used as the monomer (1), the glass transition point of the homopolymer having a repeating structure of the constitutional unit (1) is -50°C, and the proportion of the constitutional unit (1) is 73% by mass.

In a case where n-butyl acrylate is used as the monomer (2), the glass transition point of the homopolymer having a repeating structure of the constitutional unit (2) is - 56°C, and the proportion of the constitutional unit (2) is 27% by mass.

The glass transition point Tg (°C) of the acrylic resin (AC)-2 is calculated by the following equation.

$$1/(Tg + 273) = \{73/(-50 + 273) + 27/(-56 + 273)\}/100$$

Tg ≈ -52°C

In each of the obtained acrylic resins, the copolymerization compositional ratio (the proportion (% by mass) of each constitutional unit constituting the acrylic resin) of the acrylic resin was determined by $^{13}C$-NMR.

The weight-average molecular weight (Mw) of the acrylic resin was determined by gel permeation chromatography GPC measurement and was shown as a value in terms of standard polystyrene.

[Table 1]

| | | Proportion of each constitutional unit constituting acrylic resin/mass% | | | | | | | | | Characteristics of acrylic resin | | |
|---|---|---|---|---|---|---|---|---|---|---|---|---|---|
| | | Constitutional unit (ac2) | | | | | | | | Constitutional unit (acl) | | | |
| Monomer from which constitutional unit is derived | | 2-Methoxyethyl acrylate | 2-Hydroxyethyl methacrylate | n-Butyl acrylate | n-Butyl methacrylate | 2-Ethylhexyl acrylate | Styrene | Methyl methacrylate | Isobutyl methacrylate | Glycidyl methacrylate | Glass point Tg/°Cof acrylic resin | Content proportion of constitutional unit (acl) in acrylic resin/mass% | Weight-average molecular weight Mw of acrylic resin |
| Glass transition point Tg (°C) of homopolymer | | -50 | +55 | -56 | +20 | -70 | +100 | +105 | +53 | +46 | | | |
| Molecular weight of monomer | | 130 | 130 | 128 | 142 | 184 | 104 | 100 | 222 | 142 | | | |
| Acrylic resin | (AC)-1 | 0 | 2 | 27 | 0 | 69 | 0 | 0 | 0 | 2 | -63 | 2 | 80000 |
| | (AC)-2 | 73 | 0 | 27 | 0 | 0 | 0 | 0 | 0 | 0 | -52 | 0 | 290000 |
| | (AC)-3 | 72.5 | 0 | 27 | 0 | 0 | 0 | 0 | 0 | 0.5 | -51 | 05 | 300000 |
| | (AC)-4 | 72.5 | 0 | 0 | 27 | 0 | 0 | 0 | 0 | 0.5 | -34 | 05 | 350000 |
| | (AC)-5 | 38.5 | 0 | 0 | 61 | 0 | 0 | 0 | 0 | 0.5 | -12 | 05 | 250000 |
| | (AC)-6 | 73 | 0 | 25 | 0 | 0 | 0 | 0 | 0 | 2 | -50 | 2 | 310000 |
| | (AC)-7 | 97.5 | 2 | 0 | 0 | 0 | 0 | 0 | 0 | 0.5 | -48 | 05 | 180000 |
| | (AC)-a | 70 | 25 | 0 | 0 | 0 | 0 | 0 | 0 | 5 | -27 | 5 | 140000 |
| | (AC)-9 | 80 | 0 | 0 | 10 | 0 | 0 | 0 | 0 | 10 | -37 | 10 | 110000 |
| | (AC)-10 | 50 | 0 | 0 | 0 | 0 | 0 | 0 | 0 | 50 | -11 | 50 | 100000 |
| | (AC)-11 | 27 | 0 | 0 | 0 | 0 | 73 | 0 | 0 | 0 | +43 | 0 | 300000 |
| | (AC)-12 | 23 | 0 | 0 | 75 | 0 | 0 | 0 | 0 | 2 | +1 | 2 | 300000 |
| | (AC)-13 | 0 | 28 | 0 | 0 | 0 | 0 | 42 | 30 | 0 | +74 | 0 | 120000 |
| | (AC)-14 | 0 | 0 | 0 | 0 | 0 | 0 | 59 | 41 | 0 | +82 | 0 | 51000 |

<Preparation of photocurable composition>

(Examples 1 to 11 and Comparative Examples 1 to 7)

The components listed in Tables 2 and 3 were mixed and dissolved in methyl ethyl ketone, and the mixture was filtered through a PTFE filter (pore diameter of 1 μm, manufactured by Pall Corporation), thereby preparing a photocurable composition (solution having a solid content concentration of 73% by mass, viscosity at 23°C: 1,500 mPa·s) of each example.

[Table 2]

| | Acrylic resin | Epoxy group-containing compound | | Cationic polymerization initiator |
|---|---|---|---|---|
| | Component (AC) | Component (A1) | Component (A2) | Component (1) |
| Example 1 | (AC)-3 [20] | - | (A2)-1 [80] | (I)-1 [0.5] |
| Example 2 | (AC)-3 [10] | - | (A2)-1 [90] | (I)-1 [0.5] |
| Example 3 | (AC)-3 [20] | (A1)-1 [80] | - | (I)-1 [0.5] |
| Example 4 | (AC)-4 [20] | (A1)-1 [80] | - | (I)-1 [0.5] |
| Example 5 | (AC)-5 [20] | (A1)-1 [80] | - | (I)-1 [0.5] |
| Example 6 | (AC)-7 [30] | (A1)-1 [70] | - | (I)-1 [0.5] |
| Example 7 | (AC)-1 [20] | (A1)-1 [80] | - | (I)-1 [0.5] |
| Example 8 | (AC)-6 [20] | - | (A2)-1 [80] | (I)-1 [0.5] |
| Example 9 | (AC)-8 [20] | - | (A2)-1 [80] | (I)-1 [0.5] |
| Example 10 | (AC)-9 [20] | - | (A2)-2 [80] | (I)-1 [0.5] |
| Example 11 | (AC)-3 [20] | (A1)-1 [32] | (A2)-1 [48] | (I)-1 [0.5] |

[Table 3]

| | Acrylic resin | Epoxy group-containing compound | | Cationic polymerization initiator |
|---|---|---|---|---|
| | Component (AC) | Component (Al) | Component (A2) | Component (1) |
| Comparative Example 1 | (AC)-11 [20] | - | (A2)-1 [80] | (I)-1 [0.5] |
| Comparative Example 2 | (AC)-13 [20] | - | (A2)-1 [80] | (I)-1 [0.5] |
| Comparative Example 3 | (AC)-14 [20] | (A1)-1 [80] | - | (I)-1 [0.5] |
| Comparative Example 4 | - | (A1)-1 [100] | - | (I)-1 [0.5] |
| Comparative Example 5 | (AC)-2 [70] | - | (A2)-1 [30] | (I)-1 [0.5] |
| Comparative Example 6 | (AC)-10 [20] | - | (A2)-1 [80] | (I)-1 [0.5] |
| Comparative Example 7 | (AC)-12 [20] | - | (A2)-1 [80] | (I)-1 [0.5] |

In Tables 2 and 3, each abbreviation has the following meaning. The numerical values in the brackets denote the blending amounts of the components (parts by mass; in terms of solid content).

(AC)-1 to (AC)-14: acrylic resins (AC)-1 to (AC)-14 listed in Table 1

(A1)-1: solid novolac type epoxy resin represented by Chemical Formula (anv0-1), trade name "jER-157570", manufactured by Mitsubishi Chemical Corporation, softening point of 70°C, glass transition point of 210°C, and epoxy equivalent of 200 to 220 g/eq.

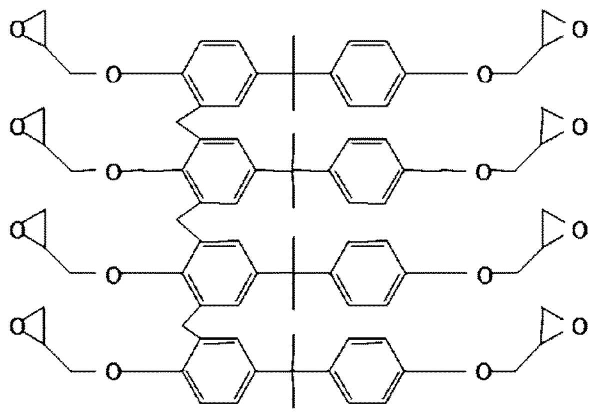

・・・(anv0−1)

(A2)-1: solid bisphenol type epoxy resin represented by Chemical Formula (abp1-0), trade name "jER-1002", manufactured by Mitsubishi Chemical Corporation, softening point of 78°C, weight-average molecular weight of 1,200, epoxy equivalent of 600 to 700 g/eq.

(A2)-2: solid bisphenol type epoxy resin represented by Chemical Formula (abp1-0), trade name "jER-1003", manufactured by Mitsubishi Chemical Corporation, softening point of 89°C, weight-average molecular weight of 1,300, epoxy equivalent of 670 to 770 g/eq.

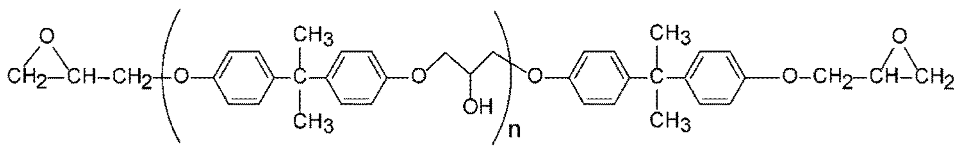

・・・(abp1−0)

(I)-1: cationic polymerization initiator represented by Chemical Formula (I2-1-2)

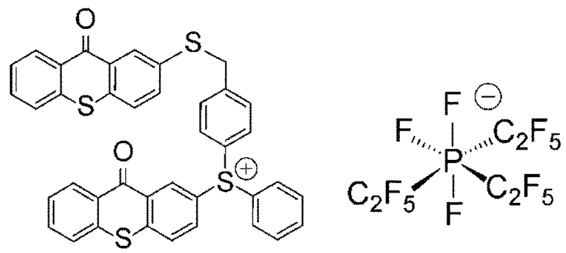

・・・(I2−1−2)

<Evaluation>

The adhesiveness, the chemical resistance, and the lithography characteristics of the photocurable composition of each example were evaluated by the evaluation methods described below. The results are listed in Tables 4 and 5.

[Evaluation of adhesiveness]

Preparation of substrate for measurement:

A silicon substrate was spin-coated with the photocurable composition of each example, and sequentially subjected to a bake treatment at 60°C for 5 minutes, 70°C for 5 minutes, and 80°C for 10 minutes in an oven, thereby forming a cured film having a film thickness of 20 μm.

Next, the cured film formed on the silicon substrate and a 5 mm square silicon chip were bonded to each other. Thereafter, the cured film and the 5 mm square silicon chip were thermocompression-bonded to each other with a load

of 3,500 g for 60 seconds using a chip bonder (manufactured by TRESKY, die bonder) in a state of being heated to 150°C, thereby preparing a substrate for measurement.

. Measurement of shear strength

The substrate for measurement was fixed under the condition of room temperature (23°C) by using a bond tester (Condor Sigma, manufactured by XYZTEC), a shearing force was applied to the 5 mm square silicon chip, and the force (shear strength, $N/mm^2$) required to peel off the 5 mm square silicon chip from the cured film was measured.

· Evaluation of bonded state

The adhesiveness was evaluated by observing the bonded state using the shear strength between the cured film and the 5 mm square silicon chip as an index according to the following evaluation criteria.

Evaluation criteria

O: The shear strength was 5 $N/mm^2$ or greater, and both were firmly bonded to each other.
X: The shear strength was less than 5 $N/mm^2$, and the adhesive strength was weak, and the 5 mm square silicon chip was easily peeled off from the cured film.

[Evaluation of chemical resistance]

Dimethyl sulfoxide (DMSO), N-methylpyrrolidone (NMP), and a 2% tetramethylammonium hydroxide aqueous solution (TMAHaq.) were mixed to prepare a mixed solvent having a mixed volume ratio (DMSO/NMP/TMAHaq.) of 80/10/10.
In addition to this process, a photocurable resin pattern was formed by performing the film formation step, the exposure step, and the development step described below.

Film formation step:

A silicon substrate was spin-coated with the photocurable composition of each example. Next, the silicon substrate was sequentially subjected to a bake treatment at 60°C for 5 minutes, 70°C for 5 minutes, and 80°C for 10 minutes in an oven, thereby forming a photocurable film having a film thickness of 20 μm.

Exposure step:

Next, the photocurable film was irradiated with g-line, h-line, and i-line using an exposure machine (Prisma ghi).
Next, the exposed photocurable film was heated on a hot plate at 90°C for 5 minutes after the exposure.

Development step:

Next, the photocurable film which had been heated after exposure was subjected to puddle development at room temperature (23°C) for 15 minutes using propylene glycol monomethyl ether acetate (PGMEA) as a developing solution.
A line and space pattern (hereinafter, referred to as "L/S pattern") having a line width of 100 μm and a space width of 300 μm was intended to be formed as the photocurable resin pattern by performing the film formation step, the exposure step, and the development step described above.
The photocurable resin pattern was immersed in the mixed solvent at room temperature (23°C) for 30 minutes. Thereafter, the chemical resistance was evaluated by observing a state of peeling off of the photocurable resin pattern from the silicon substrate according to the following evaluation criteria.

Evaluation criteria

O: Peeling was not found in the photocurable resin pattern.
Δ: The photocurable resin pattern was partially peeled off.
X: Peeling was found in the entire photocurable resin pattern.

[Evaluation of lithography characteristics]

Each pattern was formed using the photocurable composition of each example.

Film formation step:

A silicon substrate was spin-coated with the photocurable composition of each example. Next, the silicon substrate was sequentially subjected to a bake treatment at 60°C for 5 minutes, 70°C for 5 minutes, and 80°C for 10 minutes in an oven, thereby forming a photocurable film having a film thickness of 20 μm.

Exposure step:

Next, the photocurable film was irradiated with g-line, h-line, and i-line using an exposure machine (Prisma ghi).
Next, the exposed photocurable film was heated on a hot plate at 90°C for 5 minutes after the exposure.

Development step:

Next, the photocurable film which had been heated after exposure was subjected to puddle development at room temperature (23°C) for 15 minutes using propylene glycol monomethyl ether acetate (PGMEA) as a developing solution.
A line and space pattern (hereinafter, referred to as "L/S pattern") having a line width of 100 μm and a space width of 300 μm was intended to be formed by performing the film formation step, the exposure step, and the development step described above. In addition, the lithography characteristics were evaluated by observing the state of the L/S pattern according to the following evaluation criteria.

Evaluation criteria

O: A line having a width of 100 μm was formed in a satisfactory shape.
X: The shape of the L/S pattern was poor.

[Table 4]

| | Adhesiveness | | Chemical resistance | Lithography characteristics 100/300 μm L/S |
|---|---|---|---|---|
| | Shear strength $N/mm^2$ | Bonded state | Presence of peeling of pattern | |
| Example 1 | 36.3 | O | O | O |
| Example 2 | 17.2 | O | O | O |
| Example 3 | 14.0 | O | O | O |
| Example 4 | 13.1 | O | O | O |
| Example 5 | 5.8 | O | O | O |
| Example 6 | 21.0 | O | O | O |
| Example 7 | 10.1 | O | O | O |
| Example 8 | 20.2 | O | O | O |
| Example 9 | 18.3 | O | O | O |
| Example 10 | 25.2 | O | O | O |
| Example 11 | 28.9 | O | O | O |

[Table 5]

| | Adhesiveness | | Chemical resistance | Lithography characteristics 100/300 µm L/S |
|---|---|---|---|---|
| | Shear strength $N/mm^2$ | Bonded state | Presence of peeling of pattern | |
| Comparative Example 1 | 2.5 | X | X | O |
| Comparative Example 2 | 1.6 | X | X | O |
| Comparative Example 3 | 0.9 | X | X | O |
| Comparative Example 4 | 0.8 | X | X | O |
| Comparative Example 5 | 41.8 | O | X | X |
| Comparative Example 6 | 20.2 | O | X | O |
| Comparative Example 7 | 3.5 | X | O | O |

As shown in the results listed Tables 4 and 5, it was confirmed that the photocurable compositions of Examples 1 to 11, to which the present invention had been applied, had enhanced adhesiveness to an object in a case of being formed into a cured film and had excellent chemical resistance.

In addition, it was confirmed that a pattern having a satisfactory shape was formed with the photocurable resin compositions of Examples 1 to 11 in the pattern formation, and the photocurable resin compositions had excellent lithography characteristics.

On the contrary, in the photocurable compositions of Comparative Examples 1 to 7, which were outside the scope of the present invention, one or both of the adhesiveness and the chemical resistance were poor according to the evaluation results.

Hereinbefore, the preferable examples of the present invention have been described, but the present invention is not limited thereto. Additions, omissions, substitutions, and other modifications can be made without departing from the scope of the present invention. The present invention is not limited by the description above, but is limited only by the appended claims.

## Claims

**1.** A photocurable composition comprising:

an acrylic resin (AC);
an epoxy group-containing compound (A) (excluding a component corresponding to the acrylic resin (AC)); and a cationic polymerization initiator (I),
wherein the acrylic resin (AC) has a glass transition point of 0°C or lower and has a constitutional unit (ac1) derived from an epoxy group-containing acrylic monomer, and
a content proportion of the constitutional unit (ac1) in a total amount (100% by mass) of all constitutional units constituting the acrylic resin (AC) is greater than 0% by mass and less than 50% by mass.

**2.** The photocurable composition according to Claim 1,
wherein a mixing ratio of the epoxy group-containing compound (A) to the acrylic resin (AC) (epoxy group-containing compound (A)/acrylic resin (AC)) is in a range of 60/40 to 95/5 in terms of a mass ratio.

**3.** The photocurable composition according to Claim 1 or 2,
wherein the epoxy group-containing compound (A) contains at least one epoxy resin selected from the group consisting of a bisphenol type epoxy resin and a novolac type epoxy resin.

**4.** The photocurable composition according to Claim 1 or 2, wherein a content of the cationic polymerization initiator (I) is in a range of 0.05 to 5 parts by mass with respect to 100 parts by mass of a total content of the acrylic resin (AC) and the epoxy group-containing compound (A).

**5.** A method for forming a pattern, comprising:

a step of forming a photocurable film on a support using the photocurable composition according to Claim 1 or 2;
a step of exposing the photocurable film to light; and
a step of developing the photocurable film exposed to light with a developing solution containing an organic solvent, to form a negative tone pattern.

**INTERNATIONAL SEARCH REPORT**

International application No.
**PCT/JP2022/045665**

**A. CLASSIFICATION OF SUBJECT MATTER**

***G03F 7/004***(2006.01)i; ***G03F 7/033***(2006.01)i; ***G03F 7/038***(2006.01)i; ***G03F 7/20***(2006.01)i
FI: G03F7/038 503; G03F7/004 503Z; G03F7/033; G03F7/20 521; G03F7/20 501

According to International Patent Classification (IPC) or to both national classification and IPC

**B. FIELDS SEARCHED**

Minimum documentation searched (classification system followed by classification symbols)

G03F7/004; G03F7/033; G03F7/038; G03F7/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2013/118680 A1 (HITACHI CHEMICAL CO., LTD.) 15 August 2013 (2013-08-15) claims, examples, paragraphs [0065], [0066], [0071], [0074] | 1-5 |
| A | WO 2017/030070 A1 (TORAY INDUSTRIES, INC.) 23 February 2017 (2017-02-23) claims, examples | 1-5 |
| A | JP 2004-347874 A (JSR CORP.) 09 December 2004 (2004-12-09) claims, examples | 1-5 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 December 2022** | **14 February 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/045665**

| Patent document cited in search report | Publication date (day/month/year) | Patent family member(s) | Publication date (day/month/year) |
|---|---|---|---|
| WO 2013/118680 A1 | 15 August 2013 | US 2015/0024173 A1<br>claims, examples, paragraphs [0090]-[0092], [0097], [0101]<br>KR 10-2014-0128947 A<br>TW 201339753 A | |
| WO 2017/030070 A1 | 23 February 2017 | US 2018/0210337 A1<br>claims, examples<br>CN 107925147 A<br>KR 10-2018-0043290 A<br>TW 201724928 A | |
| JP 2004-347874 A | 09 December 2004 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021206080 A
- JP 2002097443 A


### Non-patent literature cited in the description


- Kaji Test Research. KTR Corporation
- Polymer Material Handbook. CRONA PUBLISHING CO., LTD, 20 February 1973
- the acrylic product catalog. KYOEISHA CHEMICAL Co., Ltd,
- Polymer Data Handbook. BAIFUKAN CO., LTD, 30 January 1986